# EUROPEAN PATENT APPLICATION

(11) **EP 1 818 900 A2**
(43) Date of publication of application: **15.08.2007**
(21) Application number: 07101959.0
(22) Date of filing: 08.02.2007
(51) Int. Cl.: G09G 3/32, H01L 27/32

(54) **Organic light emitting device and manufacturing method of the same**

(30) Priority: 14.02.2006 KR 20060014011
(71) Applicant: Samsung Electronics Co., Ltd., Yeongtong-gu Suwon-si, Gyeonggi-do (KR)
(72) Inventor: Choi, Joon-Hoo, Seoul (KR); Huh, Jong-Moo, Gyeonggi-do (KR)
(74) Representative: Greene, Simon Kenneth

(57) **Abstract**

The present invention relates to an organic light emitting device including a substrate (110), first (121) and second signal lines (171) formed on the substrate (110), a switching transistor connected to the first (121) and second (171) signal lines and including a first semiconductor (154a), a driving transistor connected to the switching transistor and including a second semiconductor (154b), a first electrode (191) connected to the driving transistor, a second electrode (270) facing the first electrode (191), and a light emitting member (370) formed between the first electrode (191) and the second electrode (270). The first semiconductor (154a) and the second semiconductor (154b) are formed on different layers of the display.

## Description

### BACKGROUND OF THE INVENTION

The present invention relates to an organic light emitting device (OLED) and a manufacturing method of the same. More particularly, the present invention relates to an organic light emitting device having improved characteristics and a manufacturing method of the same.

Recent trends towards lightweight and thin personal computers and television sets also require lightweight and thin display devices, and flat panel displays satisfying such requirements are being substituted for conventional cathode ray tubes ("CRTs").

Flat panel displays include a liquid crystal display ("LCD"), a field emission display ("FED"), an organic light emitting device ("OLED"), a plasma display panel ("PDP"), and so on.

Among the flat panel displays, the OLED is the most promising because of its low power consumption, fast response time, wide viewing angle, and high contrast ratio.

An OLED is a self-emissive display device that includes two electrodes and an organic light emitting layer interposed there between. One of the two electrodes injects holes and the other of the two electrodes injects electrons into the light emitting layer. The injected electrons and holes are combined to form excitons, and the excitons emit light as release energy.

The OLEDs may be divided into passive matrix OLEDs and active matrix OLEDs by their driving method.

The passive matrix OLED includes a plurality of anode lines, a plurality of cathode lines intersecting the anode lines, and a plurality of pixels, each including a light emission layer. The selection of one of the anode lines and one of the cathode lines causes light emission of the pixel located at the intersection of the selected signal lines. The active matrix OLED includes a plurality of pixels, each including a switching transistor, a driving transistor, and a storage capacitor, as well as an anode, a cathode, and a light emission layer. The driving transistor receives a data voltage from the switching transistor and drives a current having a magnitude determined depending on the data voltage, and the current from the driving transistor enters the light emission layer to cause light emission having intensity depending on the current.

Characteristics of the switching transistor and the driving transistor for optimizing characteristics of the active matrix OLED are different from each other. That is, the switching transistor requires a high current on/off characteristic lon/loff, while the driving transistor requires high mobility and high stability for flowing sufficient current to the organic light emitting diode.

When an off current of the switching transistor increases, a data voltage applied to the driving transistor decreases such that cross-talk may occur. In addition, when the mobility and the stability of the driving transistor are low, the current amount flowing to the organic light emitting diode reduces such that the light emitting amount of the organic light emitting diode decreases, image sticking occurs, and the lifetime of the organic light emitting diode is reduced.

### BRIEF SUMMARY OF THE INVENTION

According to exemplary embodiments of the present invention, an organic light emitting device includes a substrate, first and second signal lines formed on the substrate, a switching transistor connected to the first and second signal lines and including a first semiconductor, a driving transistor connected to the switching transistor and including a second semiconductor, a first electrode connected to the driving transistor, a second electrode facing the first electrode, and a light emitting member formed between the first electrode and the second electrode. The first semiconductor and the second semiconductor are formed on different layers of the display.

The first semiconductor may have a different crystalline state from a crystalline state of the second semiconductor. The first semiconductor may include an amorphous semiconductor, and the second semiconductor may include a microcrystalline semiconductor or a polycrystalline semiconductor.

The switching transistor may further include a first control electrode connected to the first signal line, a first gate insulating layer formed on the first control electrode, a first input electrode connected to the second signal line, and a first output electrode facing the first input electrode and connected to the driving transistor.

The driving transistor may further include a second control electrode connected to the first output electrode, a second gate insulating layer formed on the second control electrode, a second input electrode formed on the second semiconductor, a portion of the second input electrode overlapping the second control electrode and the second semiconductor, and a second output electrode facing the second input electrode and connected to the first electrode. The second gate insulating layer may be formed under the first control electrode.

The first control electrode, the second input electrode, and the second output electrode may be simultaneously formed using a mask.

Alternatively, the driving transistor may further include a second input electrode and a second output electrode facing each other on the second semiconductor, and a second control electrode formed on the second input electrode and the second output electrode to overlap them and the second control electrode may be connected to the first output electrode.

The first control electrode, the second input electrode, and the second output electrode may be simultaneously formed using a mask. The first input electrode, the first output electrode, and the second control electrode may be simultaneously formed using a mask.

The organic light emitting device may further include ohmic contacts formed between the second semiconductor and the second input electrode and between the second semiconductor and the second output electrode. The organic light emitting device may further include ohmic contacts formed under the second input electrode and the second output electrode. The ohmic contacts may have a substantially same planar shape as the second input electrode and the second output electrode.

The organic light emitting device may further include an auxiliary member formed under the first control electrode.

The ohmic contacts and the auxiliary member may include at least one of an impurity-doped amorphous silicon semiconductor, an impurity-doped microcrystalline semiconductor, and an impurity-doped crystalline semiconductor.

Alternatively, the driving transistor may further include a second output electrode connected to the first electrode, the second input electrode facing the second output electrode, and a second control electrode formed on the second semiconductor to overlap it and the second control electrode may be connected to the first output electrode.

The first control electrode, the second input electrode, and the second output electrode may be simultaneously formed using a mask. The first input electrode, the first output electrode, and the second control electrode may be simultaneously formed using a mask. The first control electrode may be formed under the first semiconductor, and the second control electrode may be formed on the second semiconductor.

According to other exemplary embodiments of the present invention, an organic light emitting device includes a substrate, a first signal line formed on the substrate, a first control electrode connected to the first signal line, a second signal line insulated from and intersecting the first signal line, a first input electrode connected to the second signal line, a first output electrode facing the first input electrode, a first semiconductor overlapped by the first input electrode and the first output electrode, a second control electrode connected to the first output electrode, a driving voltage line insulated from and intersecting the first signal line or the second signal line, a second input electrode connected to the driving voltage line, a second output electrode facing the second input electrode, a second semiconductor overlapped by the second input electrode and the second output electrode, a first electrode connected to the second output electrode, a second electrode facing the first electrode, and a light emitting member formed between the first electrode and the second electrode. The first control electrode, the second input electrode, and the second output electrode are formed on a same layer of the display, and the first input electrode, the first output electrode, and the second control electrode are formed on a same layer of the display.

The first semiconductor may include an amorphous semiconductor, and the second semiconductor may include a microcrystalline semiconductor or a polycrystalline semiconductor.

According to other exemplary embodiments of the present invention, a manufacturing method of an organic light emitting device includes forming a driving control electrode on a substrate, forming a first gate insulating layer on the driving control electrode; forming a driving semiconductor on the first gate insulating layer, depositing and etching a conductive layer on the first gate insulating layer and the driving semiconductor to form a switching control electrode, a driving voltage line, and a driving output electrode, forming a second gate insulating layer on the switching control electrode, the driving voltage line, and the driving output electrode, forming a switching semiconductor on the second gate insulating layer, forming a data line having a switching input electrode and a switching output electrode on the second gate insulating layer and the switching semiconductor, forming a first electrode connected to the driving output electrode, forming a light emitting member on the first electrode, and forming a second electrode on the light emitting member.

According to other exemplary embodiments of the present invention, a manufacturing method of an organic light emitting device includes forming a driving semiconductor on a substrate, depositing and etching a first conductive layer on the substrate and the driving semiconductor to form a switching control electrode, a driving voltage line, and a driving output electrode, forming a gate insulating layer on the switching control electrode, the driving voltage line, and the driving output electrode, forming a switching semiconductor on the gate insulating layer, depositing and etching a second conductive layer on the gate insulating layer and the switching semiconductor to form a data line having a switching input electrode, a switching output electrode, and a driving control electrode, forming a first electrode connected to the driving output electrode; forming a light emitting member on the first electrode, and forming a second electrode on the light emitting member.

Forming the driving semiconductor may include forming a semiconductor layer on the substrate, forming an ohmic contact layer on the semiconductor layer, and etching the semiconductor layer and the ohmic contact layer.

The manufacturing method may further include forming an ohmic contact layer after forming the driving semiconductor, and the first conductive layer and the ohmic contact layer may be simultaneously etched.

According to other exemplary embodiments of the present invention, a manufacturing method of an organic light emitting device includes depositing and etching a first conductive layer on a substrate to form a switching control electrode, a driving voltage line, and a driving output electrode, forming a driving semiconductor on the driving voltage line and the driving output electrode, forming a gate insulating layer on the driving semiconductor, forming a switching semiconductor on the gate insulating layer, depositing and etching a second conductive layer on the gate insulating layer and the switching semiconductor to form a data line having a switching input electrode, a switching output electrode, and a driving control electrode, forming a first electrode connected to the driving output electrode, forming a light emitting member on the first electrode, and forming a second electrode on the light emitting member.

Forming the driving semiconductor may include depositing a microcrystalline semiconductor. Alternatively, forming the driving semiconductor may include forming an amorphous semiconductor, and crystallizing the amorphous semiconductor.

The manufacturing method may further include forming an impurity-doped amorphous semiconductor after forming the amorphous semiconductor of the driving semiconductor, and crystallizing the amorphous semiconductor of the driving semiconductor may include simultaneously crystallizing the amorphous semiconductor of the driving semiconductor and the impurity-doped amorphous semiconductor.

Crystallizing the amorphous semiconductor of the driving semiconductor and the impurity-doped amorphous semiconductor may be performed by a solid phase crystallization process.

### BRIEF DESCRIPTION OF THE DRAWINGS

The present invention will become more apparent by describing exemplary and preferred embodiments thereof in detail with reference to the accompanying drawings, in which:
FIG. 1 is an equivalent circuit diagram of an exemplary OLED according to an exemplary embodiment of the present invention;
FIG. 2 is a layout view of a first embodiment of the exemplary OLED shown in FIG. 1;
FIG. 3 is a sectional view of the exemplary OLED shown in FIG. 2 taken along line III-III;
FIGs. 4 to 10 are sectional views of the exemplary OLED sequentially showing an exemplary manufacturing method of the exemplary OLED shown in FIGs. 2 and 3;
FIG. 11 is a layout view of a second embodiment of the exemplary OLED shown in FIG. 1;
FIG. 12 is a sectional view of the exemplary OLED shown in FIG. 11 taken along line XII-XII'-XII";
FIGs. 13 to 18 are sectional views of the exemplary OLED sequentially showing an exemplary manufacturing method of the exemplary OLED shown in FIGs. 11 and 12;
FIG. 19 is a layout view of a third embodiment of the exemplary OLED shown in FIG. 1;
FIG. 20 is a sectional view of the exemplary OLED shown in FIG. 19 taken along line XX-XX'-XX";
FIGs. 21 to 26 are sectional views of the exemplary OLED sequentially showing an exemplary manufacturing method of the exemplary OLED shown in FIGs. 19 and 20;
FIG. 27 is a layout view of a fourth embodiment of the exemplary OLED shown in FIG. 1;
FIG. 28 is a sectional view of the exemplary OLED shown in FIG. 27 taken along line XXVIII-XXVIII'-XXVIII"; and
FIGs. 29 to 34 are sectional views of the exemplary OLED sequentially showing an exemplary manufacturing method of the exemplary OLED shown in FIGs. 27 and 28.

### DETAILED DESCRIPTION OF THE INVENTION

The present invention will be described more fully hereinafter with reference to the accompanying drawings, in which exemplary and preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. Like numerals refer to like elements throughout.

It will be understood that when an element such as a layer, film, region, substrate, or panel is referred to as being "on" another element, it can be directly on the other element or intervening elements may also be present. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

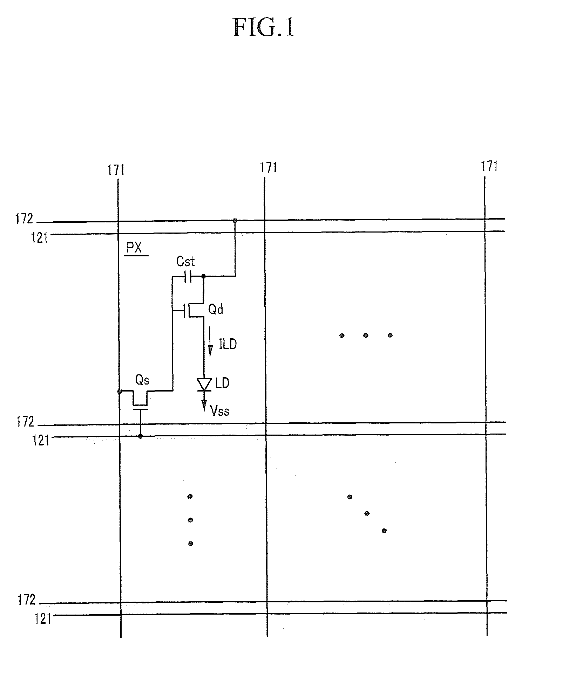

An OLED according to an exemplary embodiment of the present invention will be described with reference to FIG. 1.

FIG. 1 is an equivalent circuit diagram of an exemplary OLED according to an exemplary embodiment of the present invention.

Referring to FIG. 1, an OLED according to an exemplary embodiment of the present invention includes a plurality of signal lines 121, 171, and 172 and a plurality of pixels PX connected thereto and arranged substantially in a matrix.

The signal lines include a plurality of gate lines 121 for transmitting gate signals (or scanning signals), a plurality of data lines 171 for transmitting data signals, and a plurality of driving voltage lines 172 for transmitting a driving voltage. The gate lines 121 and the driving voltage lines 172 extend substantially in a row direction and substantially parallel to each other, while the data lines 171 extend substantially in a column direction and substantially parallel to each other. Alternatively, the driving voltage lines 172 may extend substantially in the column direction substantially parallel to the data lines 171.

Each pixel PX includes a switching transistor Qs, a driving transistor Qd, a capacitor Cst, and an organic light emitting diode LD.

The switching transistor Qs such as a thin film transistor ("TFT") has a control terminal, such as a gate electrode, connected to one of the gate lines 121, an input terminal, such as a source electrode, connected to one of the data lines 171, and an output terminal, such as a drain electrode, connected to the driving transistor Qd. The switching transistor Qs transmits the data signals applied to the data line 171 to the driving transistor Qd in response to the gate signal applied to the gate line 121.

The driving transistor Qd such as a TFT has a control terminal, such as a gate electrode, connected to the output terminal of the switching transistor Qs, an input terminal, such as a source electrode, connected to the driving signal line 172, and an output terminal, such as a drain electrode, connected to the organic light emitting diode LD. The driving transistor Qd drives an output current I_{LD} having a magnitude depending on the voltage between the control terminal and the output terminal thereof.

The capacitor Cst is connected between the control terminal and the output terminal of the driving transistor Qd. The capacitor Cst stores the data signal applied to the control terminal of the driving transistor Qd from the switching transistor Qs and maintains the data signal after the switching transistor Qd turns off.

The organic light emitting diode LD has an anode connected to the output terminal of the driving transistor Qd and a cathode connected to a common voltage Vss. The organic light emitting diode LD emits light having an intensity depending on an output current I_{LD} of the driving transistor Qd, thereby displaying images.

The switching transistor Qs and the driving transistor Qd may be n-channel field effect transistors ("FETs"). However, at least one of switching transistor Qs and the driving transistor Qd may be a p-channel FET. In addition, the connections among the transistors Qs and Qd, the capacitor Cst, and the organic light emitting diode LD may be modified.

Various examples of the OLED shown in FIG. 1 will be described with reference to the drawings.

### [First Example]

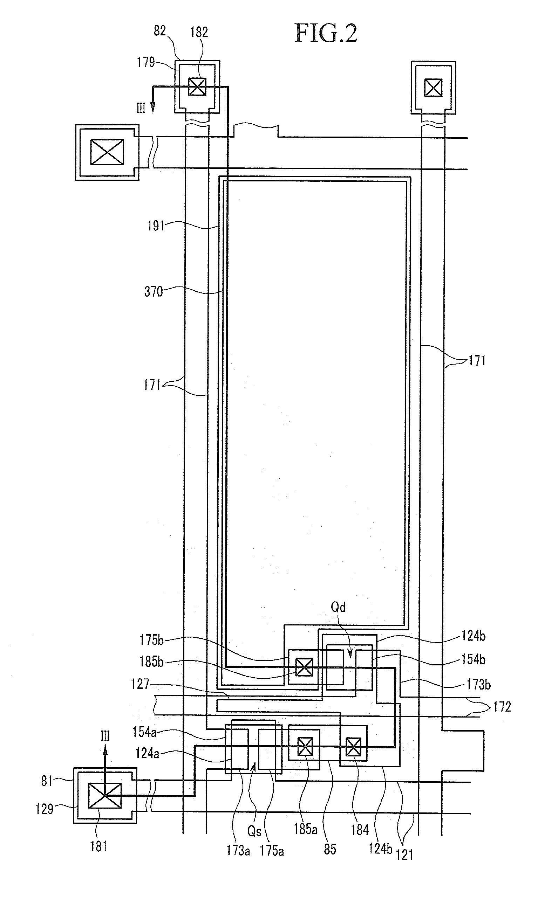

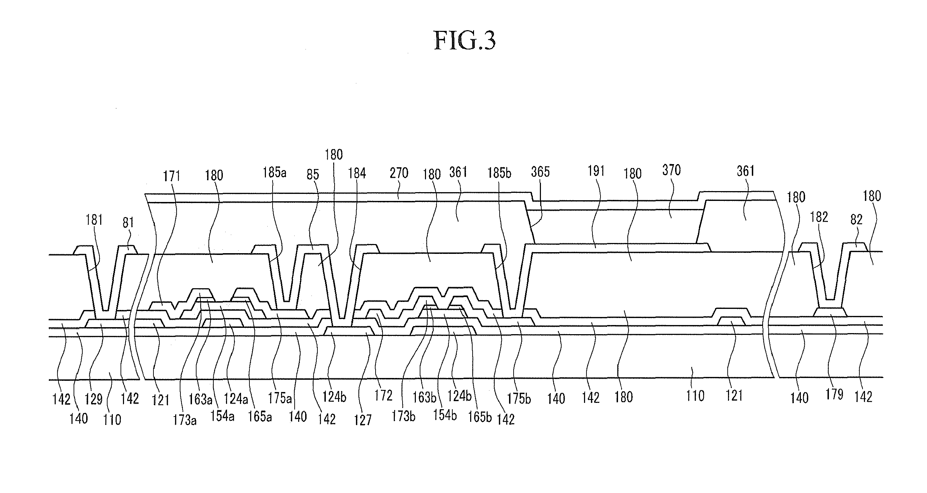

Referring to FIGs. 2 and 3, a first exemplary embodiment of the OLED shown in FIG. 1 of the present invention will be described in detail.

FIG. 2 is a layout view of an exemplary OLED according to an exemplary embodiment of the present invention, and FIG. 3 is a sectional view of the exemplary OLED shown in FIG. 2 taken along line III-III.

A plurality of driving control electrodes 124b are formed on an insulating substrate 110 made of a material such as, but not limited to, transparent glass or plastic.

Each of the driving control electrodes 124b has an island shape, and includes a storage electrode 127 extending in a transverse direction.

The driving control electrodes 124b are preferably made of an aluminum Al-containing metal such as Al and an Al alloy, a silver Ag-containing metal such as Ag and a Ag alloy, a copper Cu-containing metal such as Cu and a Cu alloy, a molybdenum Mo-containing metal such as Mo and a Mo alloy, chromium Cr, tantalum Ta, titanium Ti, etc. The driving control electrodes 124b may have a multi-layered structure including two films having different physical characteristics.

The lateral sides of the driving control electrodes 124b are inclined relative to a surface of the substrate 110, and the inclination angle thereof ranges from about 30 to about 80 degrees.

A lower gate insulating layer 140 preferably made of silicon nitride (SiNx) or silicon oxide (SiOx) is formed on the driving control electrodes 124b and on the exposed portions of the insulating substrate 110.

A plurality of driving semiconductor islands 154b are formed on the lower gate insulating layer 140. The driving semiconductor islands 154b may be made a crystalline semiconductor material such as microcrystalline silicon or polycrystalline silicon. The driving semiconductor islands 154b overlap the driving control electrodes 124b.

A plurality of gate lines 121, a plurality of driving voltage lines 172, and a plurality of driving output electrodes 175b are formed on the lower gate insulating layer 140 and the driving semiconductor islands 154b.

The gate lines 121 for transmitting gate signals extend substantially in the transverse or row direction. Each of the gate lines 121 includes an end portion 129 having a large area for contact with another layer or an external driving circuit, and a switching control electrode 124a projecting upward from the gate line 121 towards the driving voltage line 172. The gate lines 121 may extend to be directly connected to a gate driving circuit (not shown) for generating the gate signals, which may be integrated on the substrate 110.

The driving voltage lines 172 for transmitting driving voltages also extend substantially in the transverse direction and are in parallel to the gate lines 121. Each of the driving voltage lines 172 includes a plurality of driving input electrodes 173b protruding therefrom. The driving voltage lines 172 overlap the storage electrodes 127.

The driving output electrodes 175b are separated from the gate lines 121 and the driving voltage lines 172. Each pair of the driving input electrodes 173b and the driving output electrodes 175b are disposed opposite each other with respect to a driving semiconductor island 154b.

The gate lines 121, the driving voltage lines 172, and the driving output electrodes 175b may be made of a low resistivity conductor like the driving control electrodes 124b.

The gate lines 121, the driving voltage lines 172, and the driving output electrodes 175b have inclined edge profiles, and the inclination angles thereof range from about 30 to about 80 degrees.

A plurality of pairs of ohmic contact islands 163b and 165b are formed between the driving semiconductor islands 154b and the driving input electrodes 173b and between the driving semiconductor islands 154b and the driving output electrodes 175b, respectively. The ohmic contact islands 163b and 165b may be made of a material such as microcrystalline silicon or polycrystalline silicon heavily doped with an n-type impurity such as phosphorous.

An upper gate insulating layer 142 is formed on the gate lines 121, the driving voltage lines 172, and the driving output electrodes 175b, as well as on the exposed portions of the lower gate insulating layer 140 and on the portions of the driving semiconductor islands 154b exposed between the driving input and output electrodes 173b and 175b.

A plurality of switching semiconductor islands 154a made of hydrogenated amorphous silicon ("a-Si") are formed on the upper gate insulating layer 142. The switching semiconductor islands 154a overlap the switching control electrodes 124a.

A plurality of data lines 171 and a plurality of switching output electrodes 175a are formed on the switching semiconductor islands 154a and the upper gate insulating layer 142.

The data lines 171 for transmitting data signals extend substantially in a longitudinal direction, a column direction, and intersect the gate lines 121 and the driving voltage lines 172. Each of the data lines 171 includes a plurality of switching input electrodes 173a extending toward the switching control electrodes 124a and an end portion 179 having a large area for contact with another layer or an external driving circuit. The data lines 171 may extend to be directly connected to a data driving circuit (not shown) for generating the data signals, which may be integrated on the substrate 110.

The switching output electrodes 175a and the data lines 171 are separated from each other.

Each pair of the switching input electrodes 173a and the switching output electrodes 175a are disposed opposite each other with respect to the switching semiconductor island 154a.

The data lines 171 and the switching output electrodes 175a may be made of a low resistivity conductor like the driving control electrodes 124b.

The data lines 171 and the switching output electrodes 175a have inclined edge profiles, and the inclination angles thereof range from about 30 to about 80 degrees.

A plurality of pairs of ohmic contact islands 163a and 165a are formed between the switching semiconductor islands 154a and the switching input electrodes 173a and between the switching semiconductor islands 154a and the switching output electrodes 175a, respectively. The ohmic contact islands 163a and 165a may be made of n+ hydrogenated a-Si heavily doped with an n-type impurity such as phosphorous.

A passivation layer 180 is formed on the data lines 171 and the switching output electrodes 175a, and is further formed on the exposed portions of the upper gate insulating layer 142 and the portion of the switching semiconductor island 154a exposed between the switching input electrode 173a and the switching output electrode 175a.

The passivation layer 180 includes a plurality of contact holes 185a and 182 exposing the switching output electrodes 175a and the end portions 179 of the data lines 171, respectively, and the passivation layer 180 and the upper gate insulating layer 142 include a plurality of contact holes 181 and 185b exposing the end portions 129 of the gate lines 121 and the driving output electrodes 175b, respectively. The passivation layer 180, the upper gate insulating layer 142, and the lower gate insulating layer 140 include a plurality of contact holes 184 exposing the driving control electrodes 124b.

A plurality of pixel electrodes 191, a plurality of connecting members 85, and a plurality of contact assistants 81 and 82 are formed on the passivation layer 180.

The pixel electrodes 191 are electrically connected to the driving output electrodes 175b through the contact holes 185b.

The connecting members 85 are connected to the switching output electrodes 175a and the driving control electrodes 124b through the contact holes 185a and 184, respectively.

The contact assistants 81 and 82 are connected to the end portions 129 of the gate lines 121 and the end portions 179 of the data lines 171 through the contact holes 181 and 182, respectively. The contact assistants 81 and 82 protect the end portions 129 and 179 and enhance the adhesion between the end portions 129 and 179 and external devices.

The pixel electrodes 191, the connecting members 85, and the contact assistants 81 and 82 may be made of a transparent conductor such as, but not limited to, indium tin oxide ("ITO") or indium zinc oxide ("IZO"). Alternatively, when the OLED according to an exemplary embodiment of the present invention is a top-emission type, the pixel electrodes 191, the connecting members 85, and the contact assistants 81 and 82 may be made of an opaque material such as aluminum Al or an Al alloy, gold Au, platinum Pt, nickel Ni, copper Cu, or tungsten W that have a high work function, or alloys thereof.

A partition 361 is partially formed on the pixel electrodes 191, the connecting members 85, and the contact assistants 81 and 82, as well as on exposed portions of the passivation layer 180. Alternatively, the partition 361 may not be formed on the contact assistants 81 and 82, or may be removed therefrom. The partition 361 surrounds the pixel electrodes 191 like a bank to define openings 365. The partition 361 may be preferably made of an organic material having thermal resistance and solvent resistance such as acrylic resin or polyimide resin, etc., or an inorganic insulating material such as SiO₂ and TiO₂, etc., and it may have a double-layered structure. The partition 361 may be made of a photosensitive material containing a black pigment so that the black partition 361 may serve as a light blocking member and the formation of the partition 361 may be simplified.

A plurality of organic light emitting members 370 are formed on the pixel electrodes 191 and confined in the openings 365 defined by the partition 361.

Each of the organic light emitting members 370 may have a multi-layered structure including an emitting layer (not shown) for emitting light and auxiliary layers (not shown) for improving the efficiency of light emission of the emitting layer.

The light emitting layers are preferably made of a high molecular weight compound, a low molecular weight compound, or mixtures thereof each uniquely emitting one color from a set of color lights such as primary color lights, such as red, green, and blue. Examples of the high molecular weight compounds may be a polyfluorene derivative, a (poly)paraphenylenevinylene derivative, a polyphenylene derivative, polyvinylcarbazole, a polythiophene derivative, etc. Examples of the low molecular weight compounds may be anthracene such as 9,10-diphenylanthracene, butadiene such as tetraphenylbutadiene, tetracene, a distyrylarylene derivative, a benzazole derivative, a carbazole derivative, etc. Alternatively, the high or low molecular weight compound is used as a host. The host is doped by a dopant such as xanthene, perylene, cumarine, rhodamine, rubrene, a dicyanomethylenepyran compound, a thiopyran compound, a (thia)pyrilium compound, a periflanthene derivative, an indenoperylene derivative, a carbostyryl compound, Nile red, and quinacridone to enhance the efficiency of light emission.

The OLED displays images by spatially adding the monochromatic color lights emitted from the light emitting layers.

The auxiliary layers may include an electron transport layer (not shown) and a hole transport layer (not shown) for improving the balance of the electrons and holes, and an electron injecting layer (not shown) and a hole injecting layer (not shown) for improving the injection of the electrons and holes, and the auxiliary layers may include one or more of the layers. The hole transport layer and the hole injecting layer are preferably made of a material having a work function of a magnitude that is intermediate between that of the pixel electrode 191 and the light emitting layer, and the electron transport layer and the electron injecting layer are preferably made of a material having a work function that is intermediate between that of a common electrode 270 and the light emitting layers. For instance, the hole transport layer and the hole injecting layer may include a diamine compound, [4,4',4"-tris (3-methylphenyl) phenylamino]triphenylamine (MTDATA), N,N'-diphenyl-N, N'-di (3-methylphenyl)-1,1'-biphenyl-4,4'-diamine (TPD), 1,1-bis (4-di-p-tolylaminophenyl) cyclohexane, N,N,N',N'-tetra (2-naphthyl)-4,4-diamino-p-terphenyl, 4,4',4-tris[(3-methylphenyl)phenylamino]triphenylamine, polypyrrole, polyaniline, or a mixture of poly-3,4-ethylenedioxythiophene and polystyrenesulfonate (PEOOT:PSS).

In the organic light emitting members 370, by arranging the light emitting layers emitting one of the colors such as red, green, and blue corresponding to each pixel PX, the desired color may be represented through each pixel PX. Alternatively, light emitting layers for red, green, and blue may be perpendicularly or horizontally formed in each pixel PX, to form white light emitting layers, or color filters representing red, green, and blue may be formed on or under white light emitting layers to display desired colors. At this time, the color filters may be formed under the light emitting layers in a bottom-emission type of display, while the color filters may be formed on the light emitting layers in a top-emission type of display.

Alternatively, four pixels for red, green, blue, and white rather than three pixels for red, green, and blue may be disposed in a stripe shape or a mosaic shape to improve luminance.

The common electrode 270 is formed on the organic light emitting members 370 and the partition 361. The common electrode 270 is formed on the entire surface of the organic light emitting members 370, and applies a current to the organic light emitting members 370 along with the pixels electrodes 191.

In the above-described OLED, a switching control electrode 124a connected to a gate line 121, a switching input electrode 173a connected to a data line 171, and a switching output electrode 175a along with a switching semiconductor island 154a form a switching TFT Qs having a channel formed in the switching semiconductor island 154a disposed between the switching input electrode 173a and the switching output electrode 175a. A driving control electrode 124b connected to a switching output electrode 175a, a driving input electrode 173b connected to a driving voltage line 172, and a driving output electrode 175b connected to a pixel electrode 191 along with a driving semiconductor island 154b form a driving TFT Qd having a channel formed in the driving semiconductor island 154b disposed between the driving input electrode 173b and the driving output electrode 175b.

As described above, the switching semiconductor islands 154a are made of an amorphous semiconductor material, and the driving semiconductor islands 154b are made of a microcrystalline or polycrystalline semiconductor material. That is, a channel of a switching TFT Qs is formed in an amorphous semiconductor, and a channel of a driving TFT Qd is formed in a microcrystalline or polycrystalline semiconductor. It is possible to form the channels of the switching and driving TFTs Qs and Qd from different semiconductors because the semiconductors of the switching and driving TFTs Qs and Qd are formed in different layers of the OLED.

Thereby, in this example, the channels of the switching TFTs Qs and the driving TFTs Qd are formed in the different semiconductors having different crystalline states from each other, respectively, and thereby characteristics required for the respective switching and driving TFTs Qs and Qd are simultaneously satisfied.

When the channels of the driving TFTs Qd are formed in the microcrystalline or polycrystalline semiconductor, the driving TFTs Qd may have high carrier mobility and stability, and thereby a current amount flowing in an organic light emitting diode increases to improve luminance of the OLED. In addition, threshold voltage mobility due to application of a continued positive voltage to the driving TFT Qd is prevented such that the shortening of lifetime of the driving TFTs Qd is prevented, and image deterioration such as image sticking decreases.

Meanwhile, in a switching TFT Qs as opposed to a driving TFT Qd, a current on/off characteristic (lon/loff) is important, and thereby it is required to decrease an off current of the switching TFT Qs. However, if the switching TFT Qs were formed by a microcrystalline or polycrystalline semiconductor, then the off current would increase because of grain boundaries such that a data voltage drop by the switching TFT occurs to cause cross talk. Thereby, in the example, since the switching TFT Qs is formed of an amorphous semiconductor such as a-Si, of which occurrence of the off current is relatively low with respect to the microcrystalline or polycrystalline semiconductor, the data voltage drop is prevented and the cross talk decreases.

In the example, it is described that each of the pixels includes one switching TFT Qs and one driving TFT Qd, but they may further include at least one transistor and a plurality of wires for driving the transistor such that deterioration of the organic light emitting diode LD and the driving TFT Qs due to long time driving is prevented or compensated, to prevent a reduction of the life of the OLED.

A pixel electrode 191, an organic light emitting member 370, and the common electrode 270 form an organic light emitting diode LD having the pixel electrode 191 as an anode and the common electrode 270 as a cathode, or vice versa. Moreover, a storage electrode 127 and a driving voltage line 172 that overlap each other form a storage capacitor Cst.

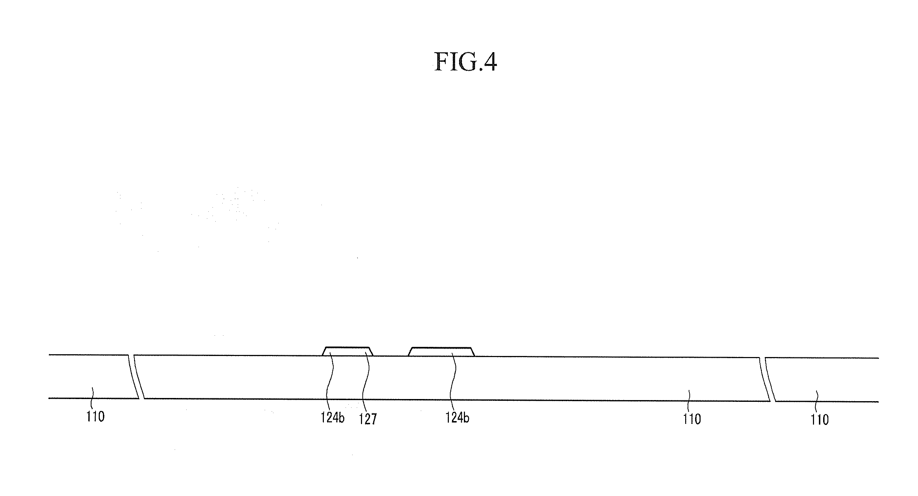

Next, an exemplary manufacturing method of the OLED shown in FIGs. 2 and 3 will be described with reference to FIGs. 4 to 10 as well as with reference to FIGs. 2 and 3.

FIGs. 4 to 10 are sectional views of the exemplary OLED sequentially showing an exemplary manufacturing method of the exemplary OLED shown in FIGs. 2 and 3.

Referring to FIG. 4, a plurality of driving control electrodes 124b, each of which includes a storage electrode 127, are formed on a substrate 110.

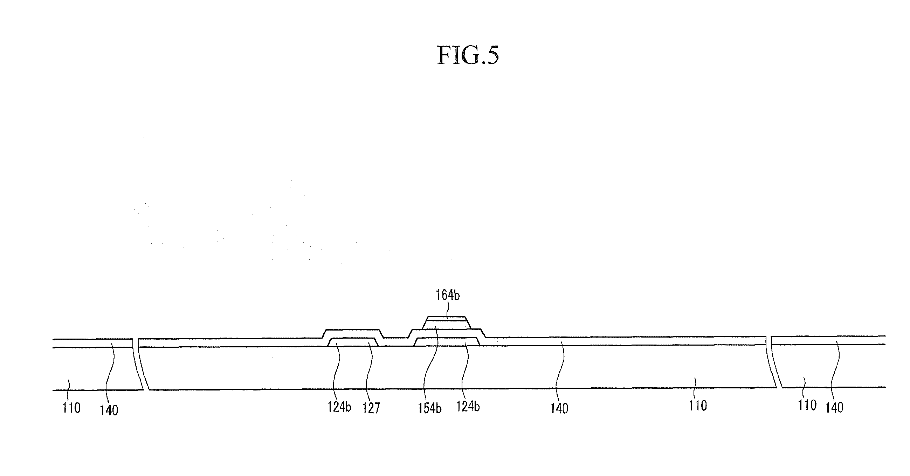

As shown in FIG. 5, a lower gate insulating layer 140, a microcrystalline silicon layer, and an impurity a-Si layer are sequentially deposited on the driving control electrodes 124b and on the exposed surfaces of the substrate 110, and then photo-etching is performed to form a plurality of driving semiconductor islands 154b and ohmic contact layers 164b.

Alternatively, a lower gate insulating layer 140, a microcrystalline silicon layer, and an impurity a-Si layer may be sequentially deposited on the driving control electrodes 124b, and then crystallized. At this time, the crystallization may be performed by a solid phase crystallization ("SPC") process, a rapid thermal annealing ("RTA") process, a liquid phase re-crystallization ("LPR") process, or an excimer laser annealing ("ELA") process, and it is preferable to be formed by the SPC process.

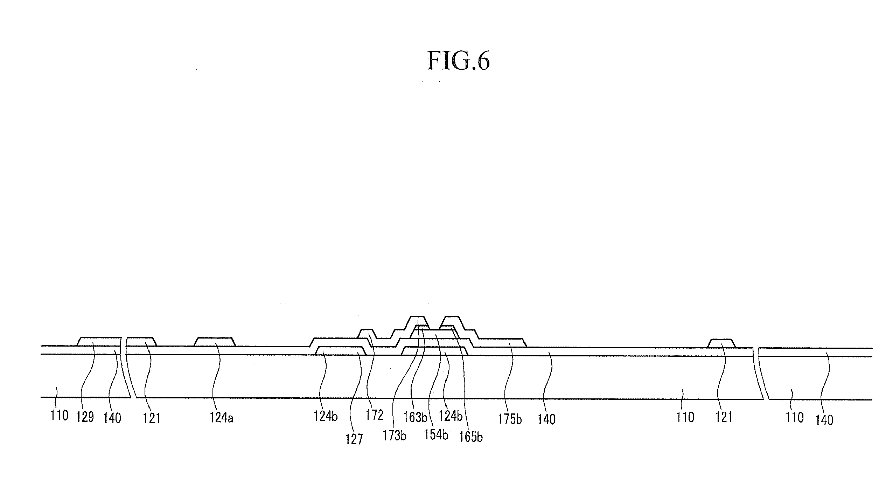

Referring to FIG. 6, a metal layer is deposited on the lower gate insulating layer 140 and the ohmic contact layers 164b of FIG. 5, and is then photo-etched to form a plurality of gate lines 121 having switching control electrodes 124a and end portions 129, a plurality of driving voltage lines 172 including driving input electrodes 173b, and a plurality of driving output electrodes 175b.

Next, the ohmic contact layers 164b are patterned using the driving voltage lines 172 having the driving input electrodes 173b and the driving output electrodes 175b as an etch mask, to form a plurality of pairs of ohmic contact islands 163b and 165b, thus exposing a channel portion of the driving semiconductor island 154b.

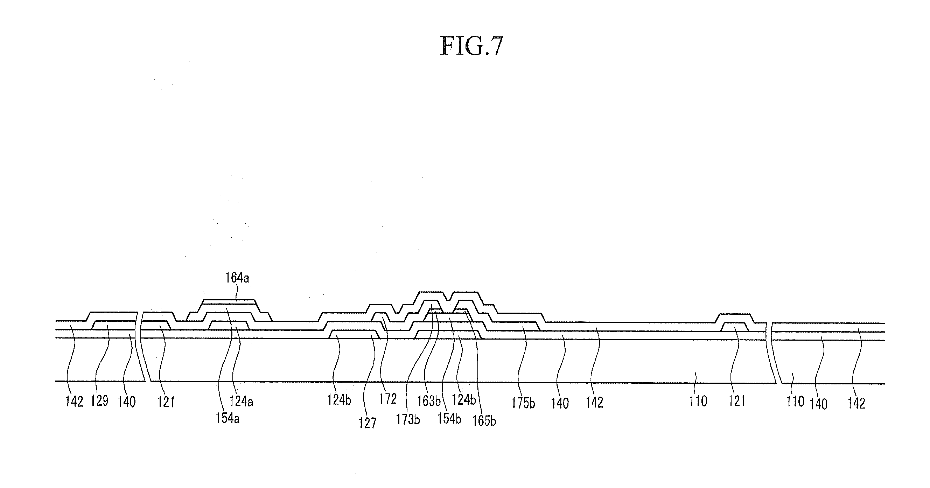

As shown in FIG. 7, an upper gate insulating layer 142, an intrinsic a-Si layer, and an impurity a-Si layer are sequentially deposited on the gate lines 121, the driving voltage lines 172, the driving output electrodes 175b, and the exposed portions of the lower gate insulating layer 140. Then, photo-etching is performed to form switching semiconductor islands 154a and ohmic contact layers 164a.

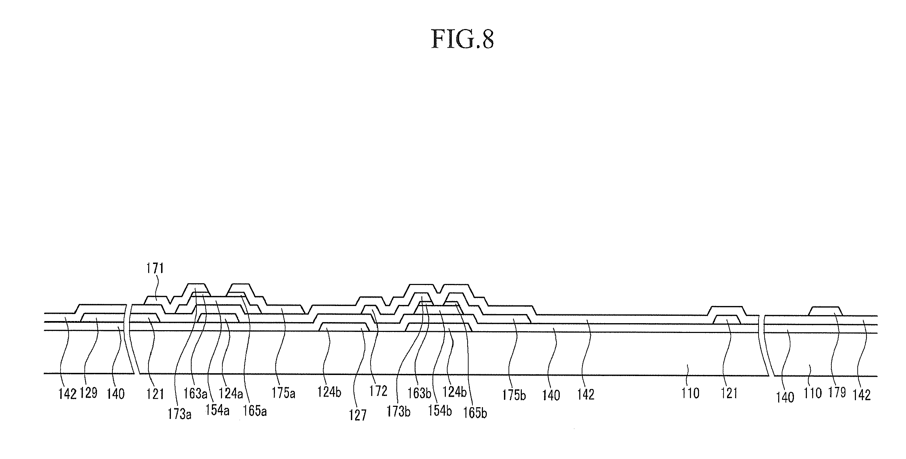

As shown in FIG. 8, a metal layer is deposited on the upper gate insulating layer 142 and the ohmic contact layers 164a and is photo-etched to form a plurality of data lines 171 including switching input electrodes 173a and end portions 179, and a plurality of switching output electrodes 175a.

Sequentially, the ohmic contact layers 164a are etched using the data lines 171 having the switching input electrodes 173a and the switching output electrodes 175a as an etch mask to form a plurality of pairs of ohmic contact islands 163a and 165a and exposing a channel portion of the switching semiconductor islands 154a there between.

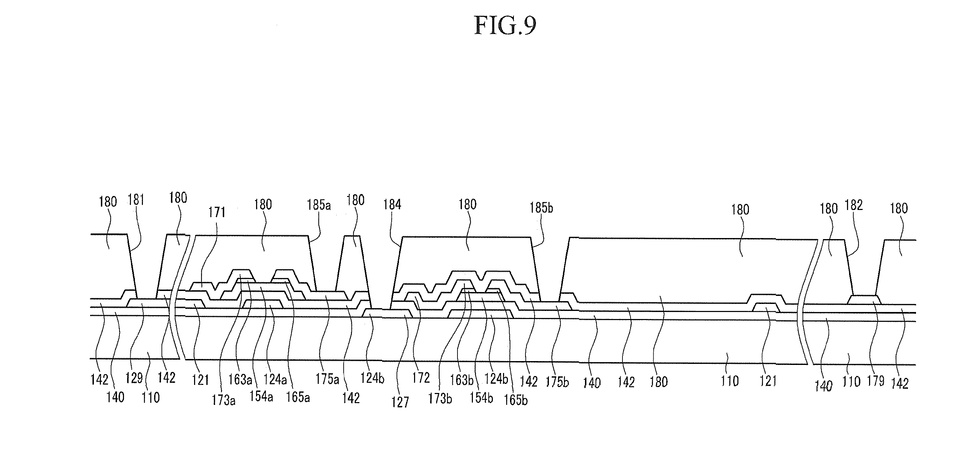

Next, as shown in FIG. 9, a passivation layer 180 is formed on the data lines 171, the switching output electrodes 175a, the upper gate insulating layer 142, and the channel portion of the switching semiconductor island 154a. Thereafter, the passivation layer 180 is etched to form a plurality of contact holes 185a and 182 exposing the switching output electrodes 175a and the end portions 179, the passivation layer 180 and the upper gate insulating layer 142 are etched to form a plurality of contact holes 181 and 185b exposing the end portions 129 and the driving output electrodes 175b, and the passivation layer 180, the upper gate insulating layer 142, and the lower gate insulating layer 140 are etched to form a plurality of contact holes 184 exposing the driving control electrodes 124b.

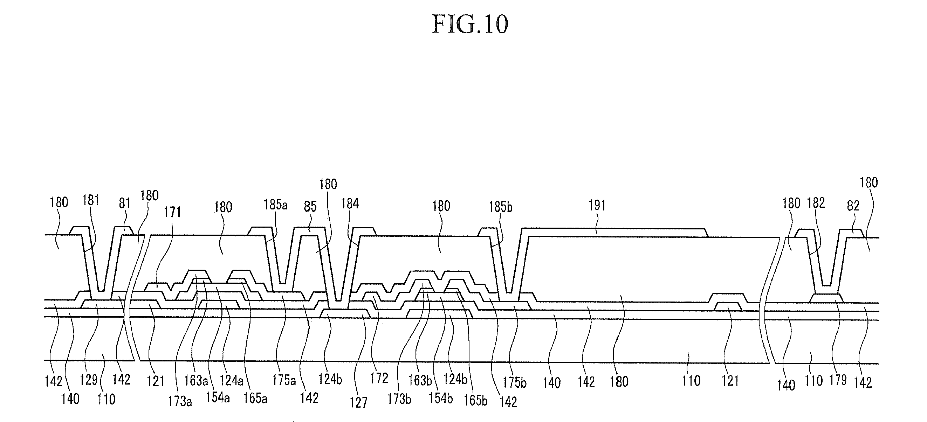

As shown in FIG. 10, ITO is deposited on the passivation layer 180. Thereafter, the ITO is photo-etched to form a plurality of pixel electrodes 191, a plurality of connecting members 85, and a plurality of contact assistants 81 and 82.

Next, with reference to FIGs. 2 and 3, after depositing a photosensitive organic layer on the pixel electrodes 191, the connecting members 85, the contact assistants 81 and 82, and the passivation layer 180, the organic layer is exposed to light and developed to form a partition 361 including a plurality of openings 365.

Thereafter, a plurality of organic light emitting members 370 of which each includes a hole transport layer (not shown) and an emitting layer (not shown) are formed on the pixel electrodes 191 and confined in the openings 365. The organic light emitting members 370 may be formed by a solution process such as an inkjet printing or a depositing process. The formation of the organic light emitting members 370 may be formed by inkjet printing that sprays solution into the openings 365 while moving an inkjet head (not shown), and in this case, a drying step for removing solvent follows.

Next, further referring to FIGs. 2 and 3, a common electrode 270 is formed on the partitions 361 and the organic light emitting members 370.

### [Second Example]

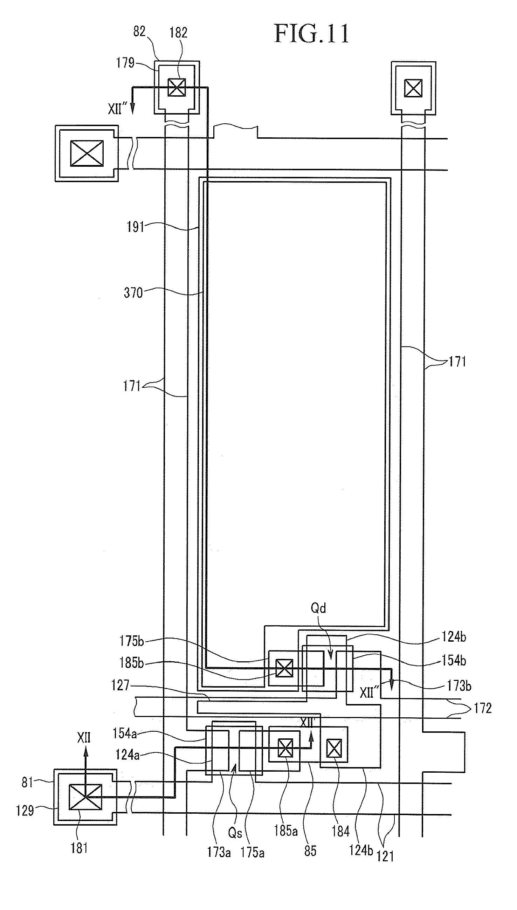

Next, a second exemplary embodiment of the exemplary OLED shown in FIG. 1 will be described with reference to FIGs. 11 and 12 as well as FIG. 1.

The OLED including the switching TFTs and the driving TFTs of a bottom gate structure is described with reference to FIGs. 2 to 10. However, in this second exemplary embodiment, an OLED having switching TFTs of the bottom gate structure and driving TFTs of a top gate structure will be described.

The descriptions overlapping the above-described example are omitted.

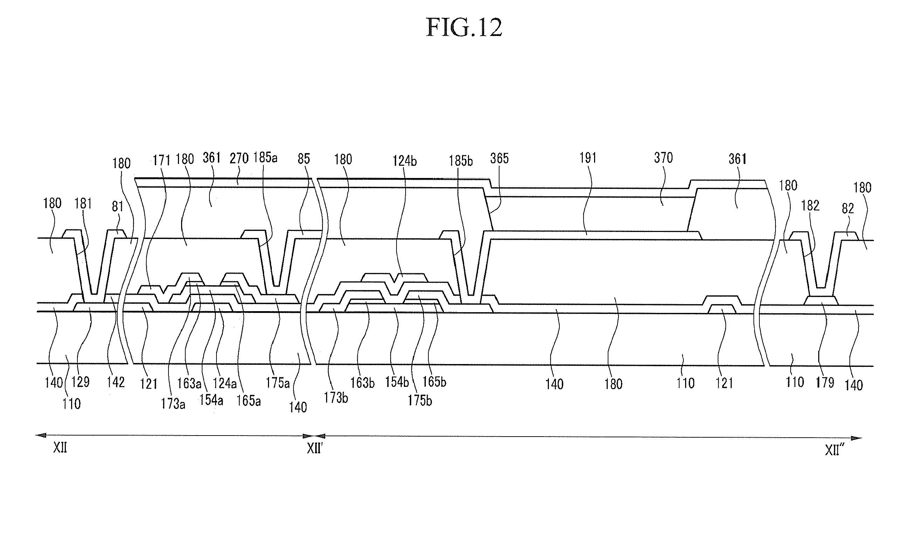

FIG. 11 is a layout view of a second exemplary embodiment of the exemplary OLED shown in FIG. 1, and FIG. 12 is a sectional view of the exemplary OLED shown in FIG. 11 taken along line XII-XII'-XII".

A plurality of driving semiconductor islands 154b made of a crystalline semiconductor material such as microcrystalline silicon or polycrystalline silicon are formed on an insulating substrate 110.

A plurality of gate lines 121 including switching control electrodes 124a and end portions 129, a plurality of driving voltage lines 172 including driving input electrodes 173b, and a plurality of driving output electrodes 175b are formed on the substrate 110 and the driving semiconductor islands 154b.

A plurality of pairs of ohmic contact islands 163b and 165b are formed between the driving semiconductor islands 154b and the driving input electrodes 173b and between the driving semiconductor islands 154b and the driving output electrodes 175b, respectively.

The ohmic contact islands 163b and 165b may be made of a-Si, microcrystalline silicon, or polycrystalline silicon heavily doped with an n-type impurity such as phosphorous.

A gate insulating layer 140 is formed on the gate lines 121, the driving voltage lines 172, and the driving output electrodes 175b, as well as on the exposed portions of the substrate 110 and the channel portion of the driving semiconductor islands 154b exposed between the driving output electrodes 175b and the driving input electrodes 173b.

A plurality of switching semiconductor islands 154a made of hydrogenated a-Si are formed on the gate insulating layer 140. The switching semiconductor islands 154a overlap the switching control electrodes 124a.

A plurality of data lines 171 including switching input electrodes 173a and end portions 179, a plurality of switching output electrodes 175a, and a plurality of driving control electrodes 124b are formed on the gate insulating layer 140 and the switching semiconductor islands 154a.

The switching input electrodes 173a and the switching output electrodes 175a overlap portions of the switching semiconductor islands 154a. Each pair of the driving input electrodes 173b and the driving output electrodes 175b are disposed opposite each other with respect to the driving semiconductor island 154b. Likewise, each pair of the switching input electrodes 173a and the switching output electrodes 175a are disposed opposite each other with respect to the driving semiconductor island 154a.

The driving control electrodes 124b are formed on the driving semiconductor islands 154b, and portions of the driving control electrodes 124b overlap the driving input electrodes 173b and the driving output electrodes 175b.

A plurality of pairs of ohmic contact islands 163a and 165a are formed between the switching semiconductor islands 154a and the switching input electrodes 173a and between the switching semiconductor islands 154a and the switching output electrodes 175a, respectively. The ohmic contact islands 163a and 165a may be made of a-Si heavily doped with an n-type impurity such as phosphorous.

A passivation layer 180 is formed on the data lines 171, the switching output electrodes 175a, and the driving control electrodes 124b, as well as on the exposed portions of the gate insulating layer 140 and the channel portion of the switching semiconductor island 154a exposed between the switching output electrode 175a and the switching input electrode 173a.

The passivation layer 180 includes a plurality of contact holes 185a, 184, and 182 exposing the switching output electrodes 175a, the driving control electrodes 124b, and the end portions 179 of the data lines 171, respectively, and the passivation layer 180 and the gate insulating layer 140 include a plurality of contact holes 181 and 185b exposing the end portions 129 of the gate lines 121 and the driving output electrodes 175b, respectively.

A plurality of pixel electrodes 191, a plurality of connecting members 85, and a plurality of contact assistants 81 and 82 are formed on the passivation layer 180.

The pixel electrodes 191 are electrically connected to the driving output electrodes 175b through the contact holes 185b, and the connecting members 85 are connected to the switching output electrodes 175a and the driving control electrodes 124b through the contact holes 185a and 184, respectively.

A partition 361 is formed on the pixel electrodes 191, the connecting members 85, and the contact assistants 81 and 82, as well as on exposed surfaces of the passivation layer 180. Alternatively, the partition 361 may be removed or not formed on one or both of the contact assistants 81 and 82.

A plurality of organic light emitting members 370 are formed on the pixel electrodes 191 and confined in the openings 365 defined by the partition 361, and a common electrode 270 is formed on the organic light emitting members 370 and the partition 361.

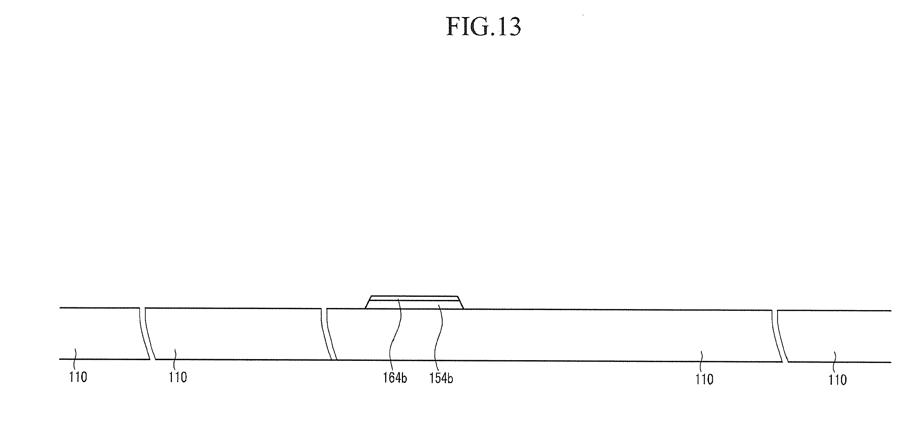

Next, an exemplary manufacturing method of the exemplary OLED shown in FIGs. 11 and 12 will be described with reference to FIGs. 13 to 18 as well as with reference to FIGs. 11 and 12.

FIGs. 13 to 18 are sectional views of the exemplary OLED sequentially showing an exemplary manufacturing method of the exemplary OLED shown in FIGs. 11 and 12.

Referring to FIG. 13, a microcrystalline silicon layer and an impurity a-Si layer are sequentially deposited on a substrate 110 and are photo-etched to form a plurality of driving semiconductor islands 154b and ohmic contact layers 164b.

Alternatively, an a-Si layer and an impurity a-Si layer may be sequentially deposited on the substrate 110, and then crystallized by an SPC process, etc.

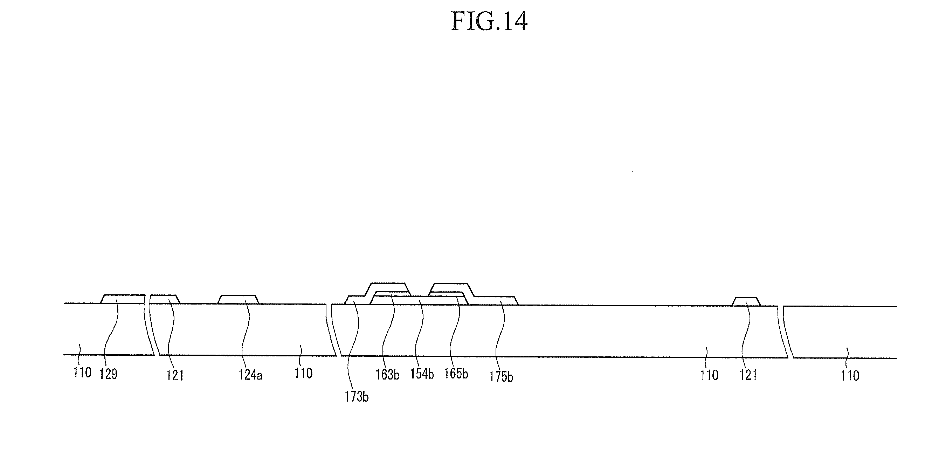

As shown in FIG. 14, a metal layer is deposited on the substrate 110 and the ohmic contact layers 164b, and is then photo-etched to form a plurality of gate lines 121 having switching control electrodes 124a and end portions 129, a plurality of driving voltage lines 172 including driving input electrodes 173b, and a plurality of driving output electrodes 175b.

Sequentially, the ohmic contact layers 164b are etched using the driving voltage lines 172 including the driving input electrodes 173b and the driving output electrodes 175b as an etch mask, to form a plurality of pairs of ohmic contact islands 163b and 165b.

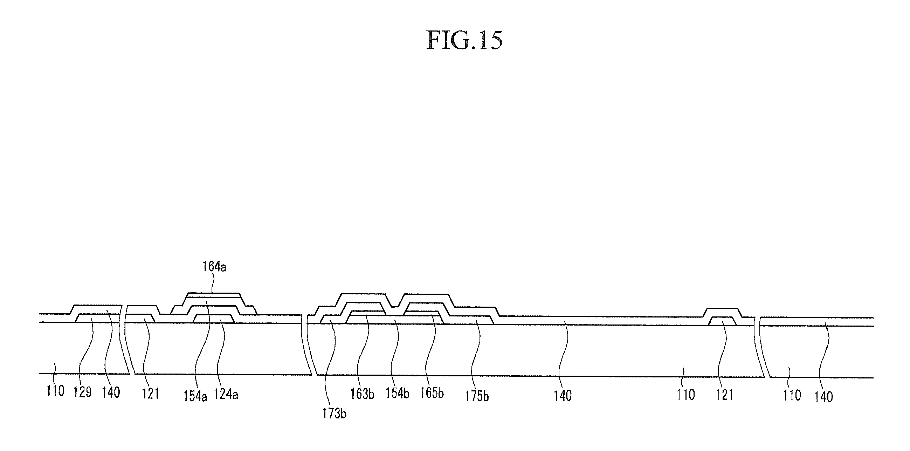

As shown in FIG. 15, a gate insulating layer 140, an intrinsic a-Si layer, and impurity a-Si layer are sequentially deposited on the gate lines 121, the driving voltage lines 172, and the driving output electrodes 175b, as well as on the exposed portions of the substrate 110 and the channel portion of the driving semiconductor island 154b. Photo-etching is then performed to form a plurality of switching semiconductor islands 154a and ohmic contact layers 164a.

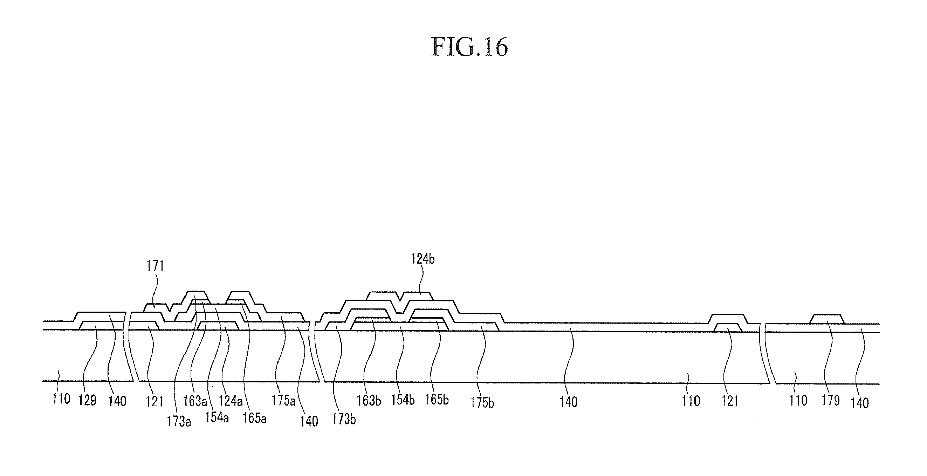

Next, as shown in FIG. 16, a metal layer is deposited on the gate insulating layer 140 and the ohmic contact layers 164a, and is photo-etched to form a plurality of data lines 171 including switching input electrodes 173a and end portions 179, a plurality of switching output electrodes 175a, and a plurality of driving control electrodes 124b. The driving control electrodes 124b overlap the driving semiconductor islands 154b.

Sequentially, the ohmic contact layers 164a are etched using the data lines 171 having the switching input electrodes 173a and the switching output electrodes 175a as a mask to form a plurality of pairs of ohmic contact islands 163a and 165a.

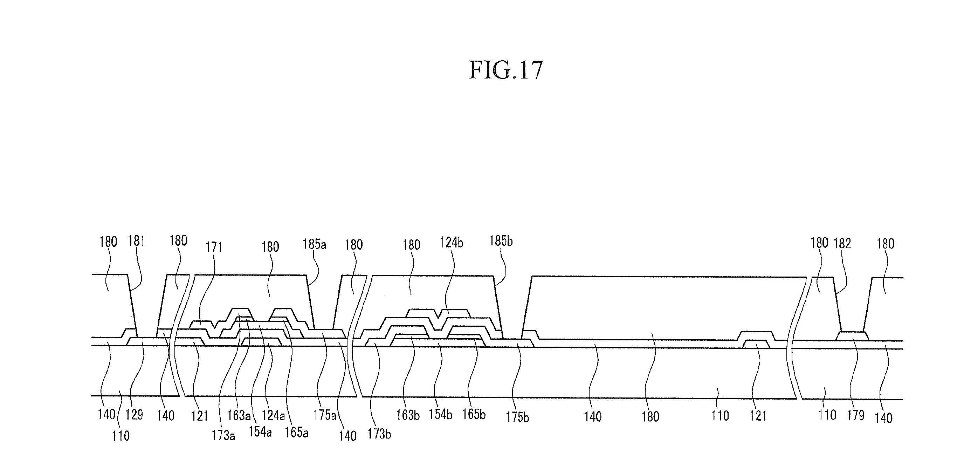

As shown in FIG. 17, a passivation layer 180 is formed on the data lines 171, the switching output electrodes 175a, the driving control electrodes 124b, the gate insulating layer 140, and a channel portion of the switching semiconductor island 154a exposed between the switching input electrodes 173a and switching output electrodes 175a. Thereafter, the passivation layer 180 is etched to form a plurality of contact holes 185a, 182, and 184, and the passivation layer 180 and the gate insulating layer 140 are etched to form a plurality of contact holes 181 and 185b.

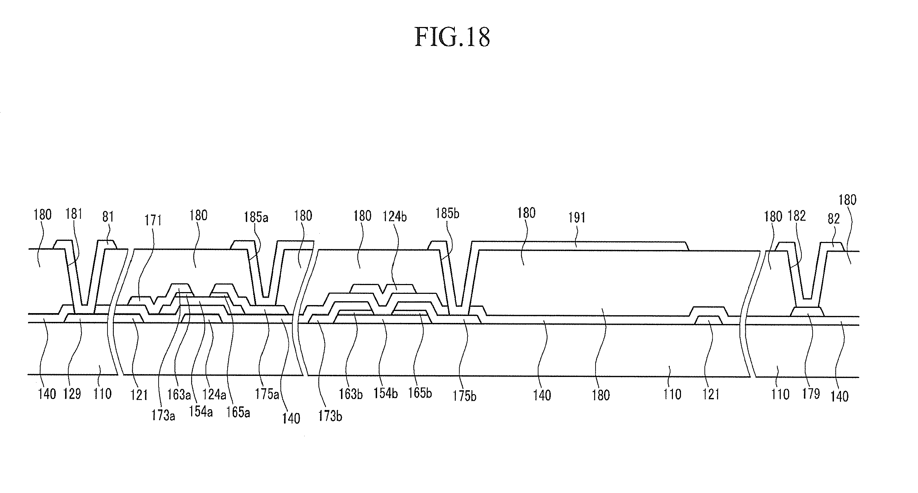

As shown in FIG. 18, ITO is deposited on the passivation layer 180 and is photo-etched to form a plurality of pixel electrodes 191, a plurality of connecting members 85, and a plurality of contact assistants 81 and 82.

Next, with reference to FIGs. 11 and 12, after depositing a photosensitive organic layer on the pixel electrodes 191, the connecting members 85, the contact assistants 81 and 82, and the passivation layer 180, the organic layer is exposed to light and developed to form a partition 361 including a plurality of openings 365.

Thereafter, a plurality of organic light emitting members 370 of which each includes a hole transport layer (not shown) and an emitting layer (not shown) are formed on the pixel electrodes 191 and confined in the openings 365.

Next, with further reference to FIGs. 11 and 12, a common electrode 270 is formed on the partitions 361 and the organic light emitting members 370.

### [Third Example]

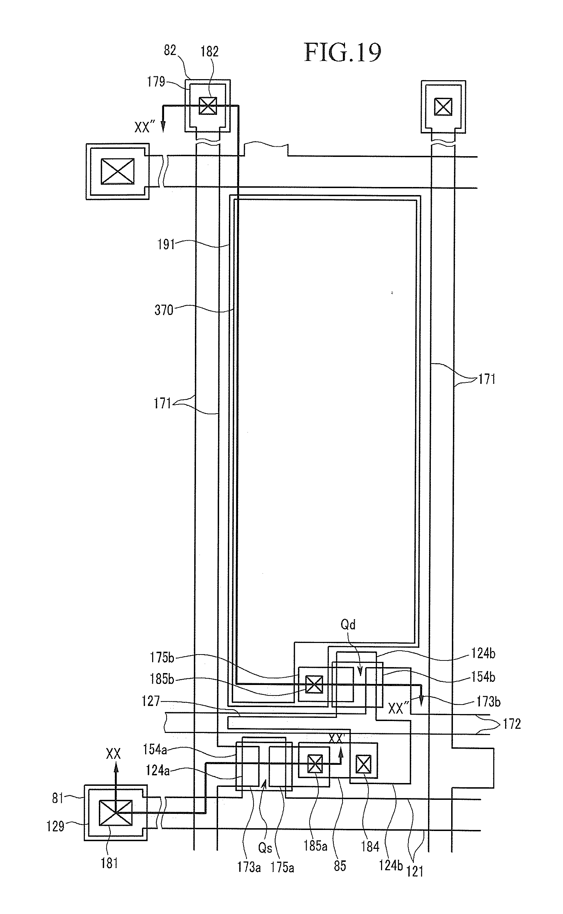

Next, a third exemplary embodiment of the exemplary OLED shown in FIG. 1 will be described with reference to FIGs. 19 and 20 as well as FIG. 1.

In this exemplary embodiment, an OLED having switching TFTs of the bottom gate structure and driving TFTs of a top gate structure different from that of the second exemplary embodiment will be described. That is, although the second exemplary embodiment also employed switching TFTs of the bottom gate structure and driving TFTs of a top gate structure, the driving TFTs of a top gate structure for the third exemplary embodiment are differently formed, as will be further described below.

The descriptions overlapping the above-described examples are omitted.

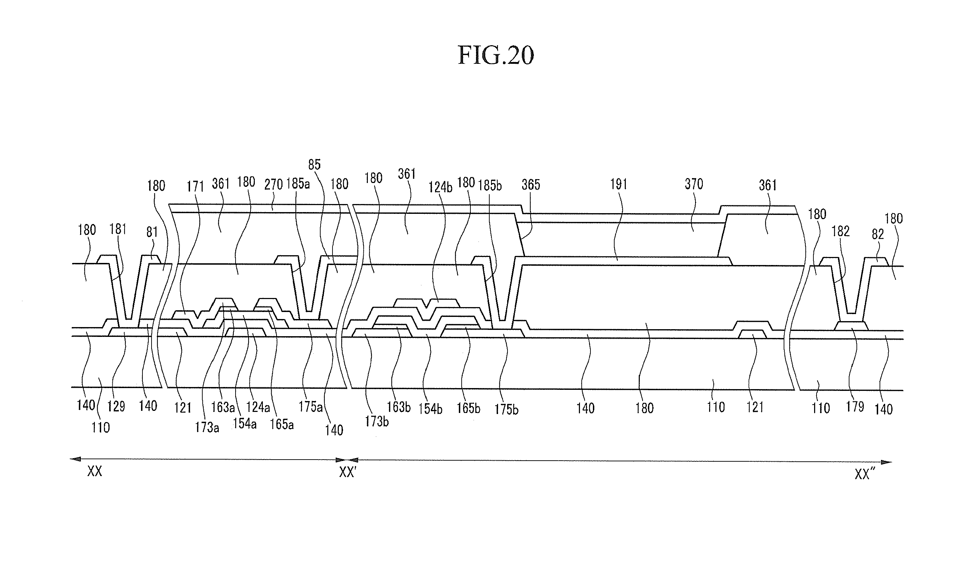

FIG. 19 is a layout view of a third exemplary embodiment of the exemplary OLED shown in FIG. 1, and FIG. 20 is a sectional view of the exemplary OLED shown in FIG. 19 taken along line XX-XX'-XX".

A plurality of gate lines 121 including switching control electrodes 124a and end portions 129, and a plurality of driving voltage lines 172 including driving input electrodes 173b and a plurality of driving output electrodes 175b are formed on a substrate 110.

A plurality of driving semiconductor islands 154b formed of a crystalline semiconductor material such as microcrystalline silicon or polycrystalline silicon are formed on the substrate 110, the driving voltage lines 172, and the driving output electrodes 175b.

Portions of the driving semiconductor islands 154b overlap the driving input electrodes 173b and the driving output electrodes 175b.

A plurality of pairs of ohmic contact islands 163b and 165b are formed between the driving semiconductor islands 154b and the driving input electrodes 173b and between the driving semiconductor islands 154b and the driving output electrodes 175b, respectively.

A gate insulating layer 140 is formed on the gate lines 121, the driving semiconductor islands 154b, the driving voltage lines 172, and the driving output electrodes 175b, as well as on exposed portions of the substrate 110.

A plurality of switching semiconductor islands 154a made of hydrogenated a-Si are formed on the gate insulating layer 140. The switching semiconductor islands 154a overlap the switching control electrodes 124a.

A plurality of data lines 171 including switching input electrodes 173a and end portions 179, a plurality of switching output electrodes 175a, and a plurality of driving control electrodes 124b are formed on the switching semiconductor islands 154a and the gate insulating layer 140.

The switching input electrodes 173a and the switching output electrodes 175a overlap portions of the switching semiconductor islands 154a. Each pair of the switching input electrodes 173a and the switching output electrodes 175a are disposed opposite each other with respect to the switching semiconductor islands 154a.

The driving control electrodes 124b are formed on the driving semiconductor islands 154b, and portions of the driving control electrodes 124b overlap the driving input electrodes 173b and the driving output electrodes 175b.

A plurality of pairs of ohmic contact islands 163a and 165a are formed between the switching semiconductor islands 154a and the switching input electrodes 173a and between the switching semiconductor islands 154a and the switching output electrodes 175a, respectively.

A passivation layer 180 is formed on the data lines 171, the switching output electrodes 175a, and the driving control electrodes 124b, as well as on exposed portions of the gate insulating layer 140 and channel portions of the switching semiconductor islands 154a exposed between the switching input electrodes 173a and the switching output electrodes 175a.

The passivation layer 180 includes a plurality of contact holes 185a, 184, and 182 exposing the switching output electrodes 175a, the driving control electrodes 124b, and the end portions 179 of the data lines 171, respectively, and the passivation layer 180 and the gate insulating layer 140 include a plurality of contact holes 181 and 185b exposing the end portions 129 of the gate lines 121 and the driving output electrodes 175b, respectively.

A plurality of pixel electrodes 191, a plurality of connecting members 85, and a plurality of contact assistants 81 and 82 are formed on the passivation layer 180.

The pixel electrodes 191 are electrically connected to the driving output electrodes 175b through the contact holes 185b, and the connecting members 85 are connected to the switching output electrodes 175a and the driving control electrodes 124b through the contact holes 185a and 184, respectively.

A partition 361 is formed on the pixel electrodes 191, the connecting members 85, and the contact assistants 81 and 82. Alternatively, the partition 361 may not be formed on one or both of the contact assistants 81 and 82, or may be removed from one or both of the contact assistants 81 and 82.

A plurality of organic light emitting members 370 are formed on the pixel electrodes 191 and confined in the openings 365 defined by the partition 361, and a common electrode 270 is formed on the organic light emitting members 370 and the partition 361.

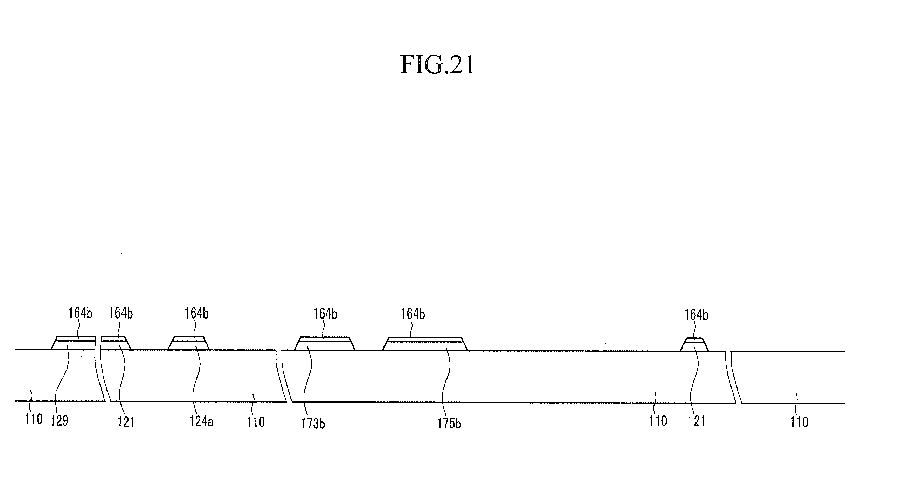

Next, an exemplary manufacturing method of the exemplary OLED shown in FIGs. 19 and 20 will be described with reference to FIGs. 21 to 26 as well as with reference to FIGs. 19 and 20.

FIGs. 21 to 26 are sectional views of the exemplary OLED sequentially showing an exemplary manufacturing method of the exemplary OLED shown in FIGs. 19 and 20.

As shown in FIG. 21, a metal layer and an impurity silicon layer are sequentially deposited on a substrate 110 and are photo-etched to form a plurality of gate lines 121 including switching control electrodes 124a and end portions 129, a plurality of driving voltage lines 172 including driving input electrodes 173b, a plurality of driving output electrodes 175b, and a plurality of impurity silicon patterns 164b.

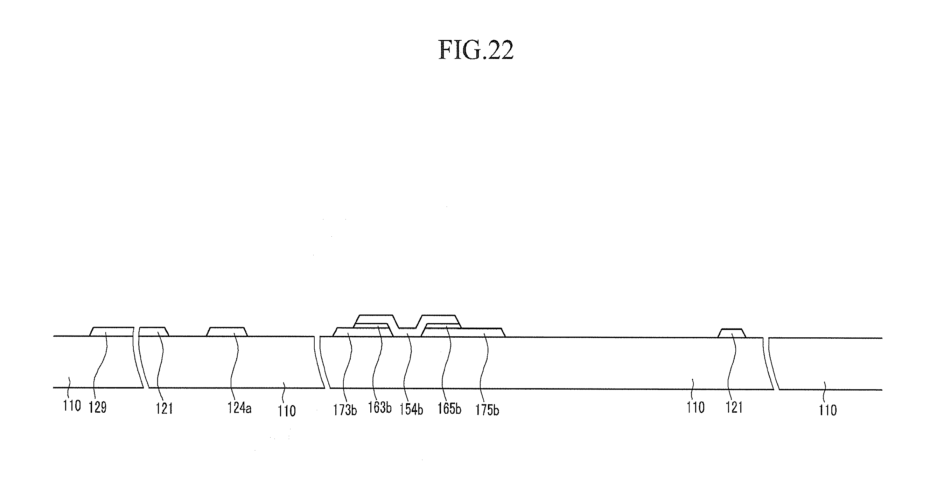

Next, as shown in FIG. 22, a microcrystalline silicon layer is deposited on the substrate 110, on the metal conductors formed from the metal layer, and on the impurity silicon patterns 164b, and is then photo-etched to form a plurality of driving semiconductor islands 154b. Then, the impurity silicon patterns 164b are etched using the driving semiconductor islands 154b as an etch mask to form a plurality of pairs of ohmic contact islands 163b and 165b.

Alternatively, an a-Si layer may be deposited on the substrate 110, on the metal conductors formed from the metal layer, and on the impurity silicon patterns 164b, and then the a-Si layer may be crystallized by an SPC process, etc.

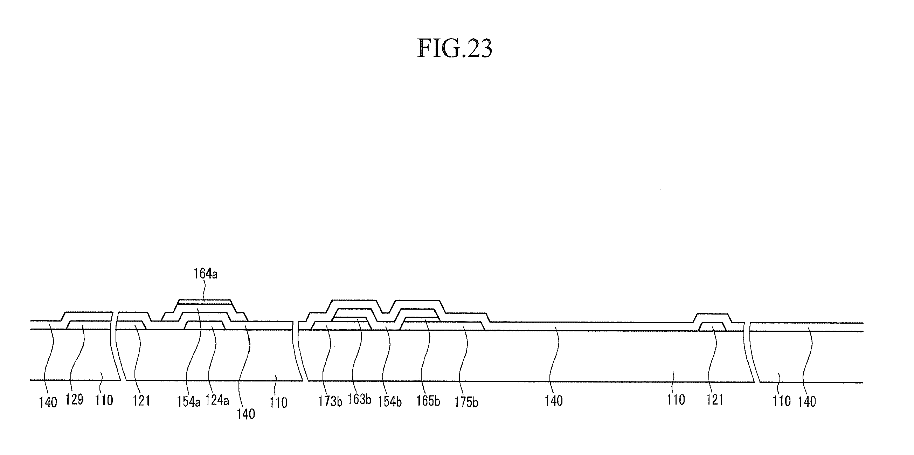

Referring to FIG. 23, a gate insulating layer 140, an intrinsic a-Si layer, and an impurity-doped a-Si layer are sequentially deposited on the substrate 110, the gate lines 121, the driving semiconductor islands 154b, the driving voltage lines 172, and the driving output electrodes 175b. Photo-etching is then performed to form a plurality of switching semiconductor islands 154a and ohmic contact layers 164a.

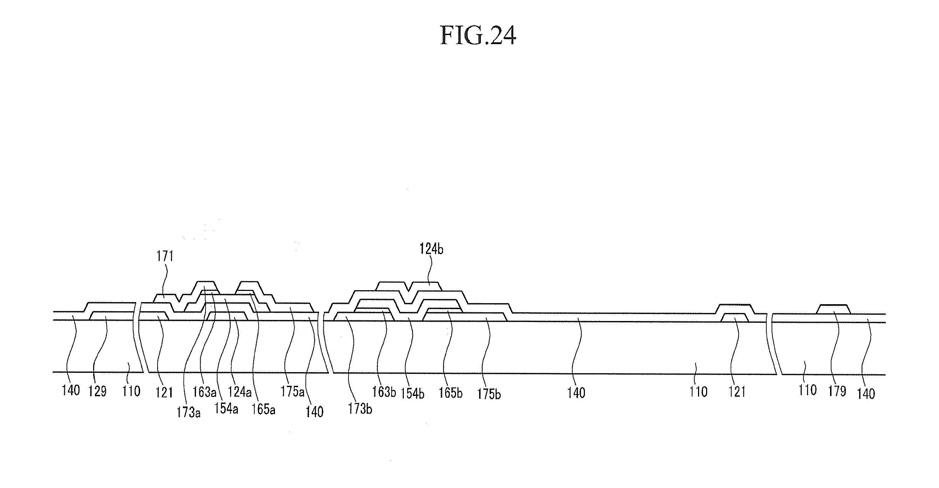

Next, as shown in FIG. 24, a metal layer is deposited on the gate insulating layer 140 and the ohmic contact layers 164a and is photo-etched to form a plurality of data lines 171 including switching input electrodes 173a and end portions 179, a plurality of switching output electrodes 175a, and a plurality of driving control electrodes 124b.

Sequentially, the ohmic contact layers 164a are etched using the data lines 171 having the switching input electrodes 173a and the switching output electrodes 175a as an etch mask to form a plurality of pairs of ohmic contact islands 163a and 165a.

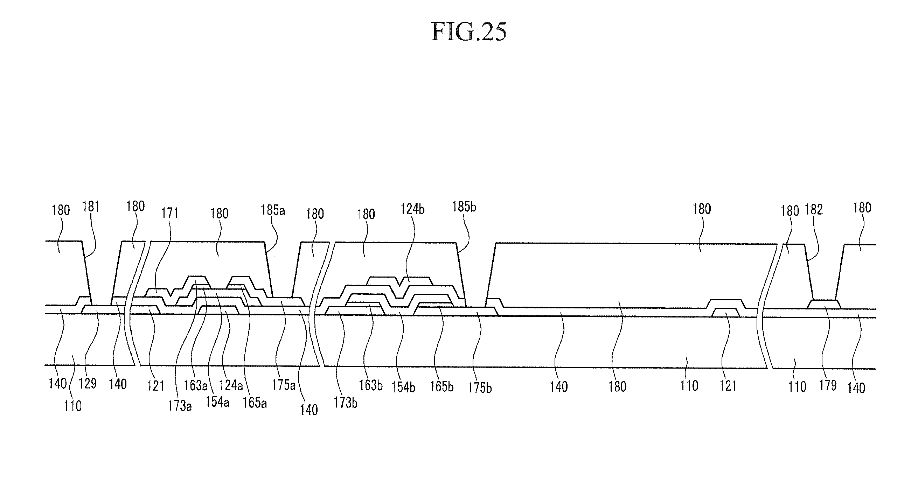

As shown in FIG. 25, a passivation layer 180 is formed on the data lines 171, the switching output electrodes 175a, the driving control electrodes 124b, and the gate insulating layer 140, as well as on channel portions of the switching semiconductor islands 154a exposed between the switching output electrodes 175a and the switching input electrodes 173a. Thereafter, the passivation layer 180 is etched to form a plurality of contact holes 185a, 182, and 184, and the passivation layer 180 and the gate insulating layer 140 are etched to form a plurality of contact holes 181 and 185b.

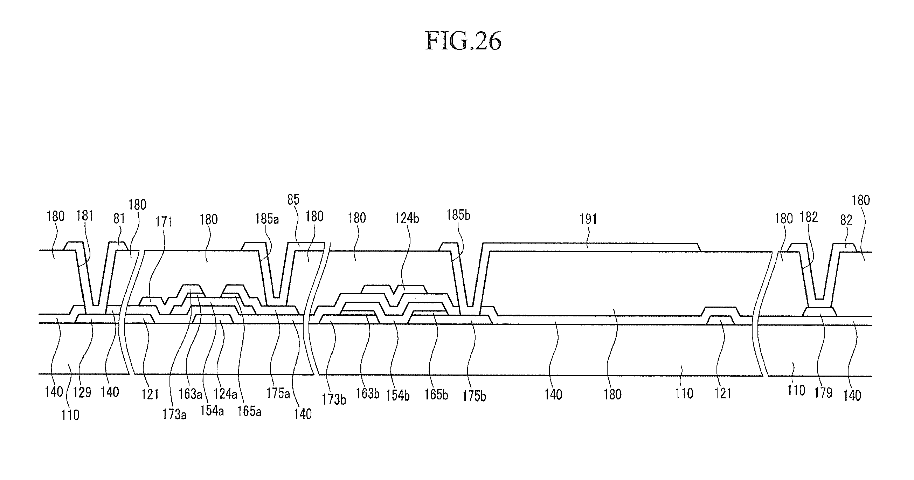

As shown in FIG. 26, ITO is deposited on the passivation layer 180 and is photo-etched to form a plurality of pixel electrodes 191, a plurality of connecting members 85, and a plurality of contact assistants 81 and 82.

Next, with reference to FIGs. 19 and 20, after depositing a photosensitive organic layer on the pixel electrodes 191, the connecting members 85, the contact assistants 81 and 82, and the passivation layer 180, the organic layer is exposed to light and developed to form a partition 361 including a plurality of openings 365.

Thereafter, a plurality of organic light emitting members 370 of which each includes a hole transport layer (not shown) and an emitting layer (not shown) are formed on the pixel electrodes 191 and confined in the openings 365.

Next, with further reference to FIGs. 19 and 20, a common electrode 270 is formed on the partitions 361 and the organic light emitting members 370.

### [Fourth Example]

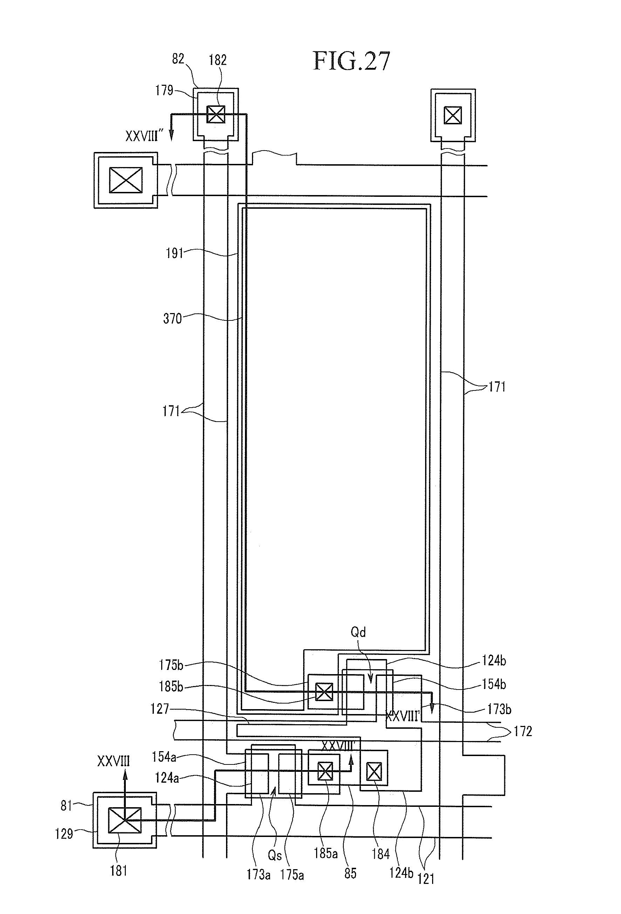

Next, a fourth exemplary embodiment of the exemplary OLED shown in FIG. 1 will be described with reference to FIGs. 27 and 28 as well as FIG. 1.

In this exemplary embodiment, an exemplary OLED having switching TFTs of the bottom gate structure and driving TFTs of yet another top gate structure different from those of the above-described examples will be described. The descriptions overlapping the above-described examples are omitted.

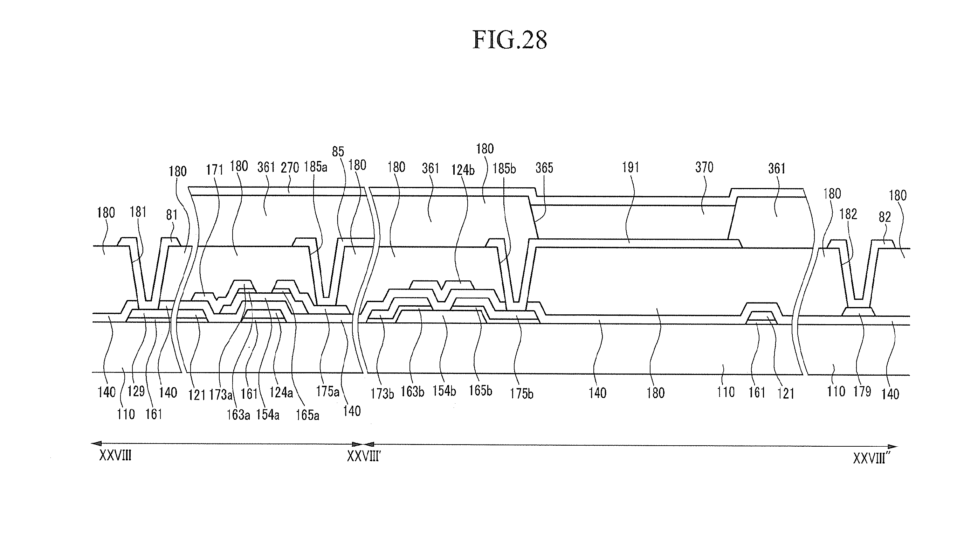

FIG. 27 is a layout view of a fourth exemplary embodiment of the exemplary OLED shown in FIG. 1, and FIG. 28 is a sectional view of the exemplary OLED shown in FIG. 27 taken along line XXVIII-XXVIII'-XXVIII".

A plurality of driving semiconductor islands 154b made of a crystalline semiconductor material such as microcrystalline silicon or polycrystalline silicon are formed on an insulating substrate 110.

A plurality of gate lines including switching control electrodes 124a and end portions 129, a plurality of driving voltage lines 172 including driving input electrodes 173b, and a plurality of output electrodes 175b are formed on the substrate 110 and the driving semiconductor islands 154b.

A plurality of pairs of ohmic contact islands 163b and 165b are formed between the driving semiconductor islands 154b and the driving voltage lines 172b and between the driving semiconductor islands 154b and the driving output electrodes 175b, respectively. At this time, the ohmic contact islands 163b and 165b have substantially the same planer shape as the driving voltage lines 172 and the driving output electrodes 175b.

Moreover, a plurality of auxiliary members 161 are formed under the gate lines 121. The auxiliary members 161 have substantially the same planar shape as the gate lines 121 and the switching control electrodes 124a and the end portions 129 of the gate lines 121.

A gate insulating layer 140 is formed on the gate lines 121, the driving voltage lines 172, and the driving output electrodes 175b, as well as on the exposed portions of the substrate 110 and the channel portions of the driving semiconductor islands 154b exposed between the driving input electrodes 173b and the driving output electrodes 175b.

A plurality of switching semiconductor islands 154a made of hydrogenated a-Si are formed on the gate insulating layer 140. The switching semiconductor islands 154a overlap the switching control electrodes 124a.

A plurality of data lines 171 including switching input electrodes 173a and end portions 179, a plurality of switching output electrodes 175a, and a plurality of driving control electrodes 124b are formed on the switching semiconductor islands 154a and the gate insulating layer 140.

The switching input electrodes 173a and the switching output electrodes 175a overlap portions of the switching semiconductor islands 154a. Each pair of the switching input electrodes 173a and the switching output electrodes 175a are disposed opposite each other with respect to the switching semiconductor islands 154a.

Portions of the driving control electrodes 124b overlap the driving semiconductor islands 154b and overlap portions of the driving input electrodes 173b and the driving output electrodes 175b.

A plurality of pairs of ohmic contact islands 163a and 165a are formed between the switching semiconductor islands 154a and the switching input electrodes 173a and between the switching semiconductor islands 154a and the switching output electrodes 175a, respectively. The ohmic contact islands 163a and 165a may be made of a-Si heavily doped with an n-type impurity such as phosphorous.

A passivation layer 180 is formed on the data lines 171, the switching output electrodes 175a, and the driving control electrodes 124b, as well as on the exposed portions of the gate insulating layer 140 and on the channel portions of the switching semiconductor islands 154a exposed between the switching output electrodes 175a and the switching input electrodes 173a.

The passivation layer 180 includes a plurality of contact holes 185a, 184, and 182 exposing the switching output electrodes 175a, the driving control electrodes 124b, and the end portions 179 of the data lines 171, respectively, and the passivation layer 180 and the gate insulating layer 140 include a plurality of contact holes 181 and 185b exposing the end portions 129 of the gate lines 121 and the driving output electrodes 175b, respectively.

A plurality of pixel electrodes 191, a plurality of connecting members 85, and a plurality of contact assistants 81 and 82 are formed on the passivation layer 180.

The pixel electrodes 191 are electrically connected to the driving output electrodes 175b through the contact holes 185b, and the connecting members 85 are connected to the switching output electrodes 175a and the driving control electrodes 124b through the contact holes 185a and 184, respectively.

A partition 361 is formed on the pixel electrodes 191, the connecting members 85, and the contact assistants 81 and 82. Alternatively, the partition 361 may not be formed on one or both of the contact assistants 81 and 82, and may be removed from one or both of the contact assistants 81 and 82.

A plurality of organic light emitting members 370 are formed on the pixel electrodes 191 and confined in the openings 365 defined by the partition 361, and a common electrode 270 is formed on the organic light emitting members 370 and the partition 361.

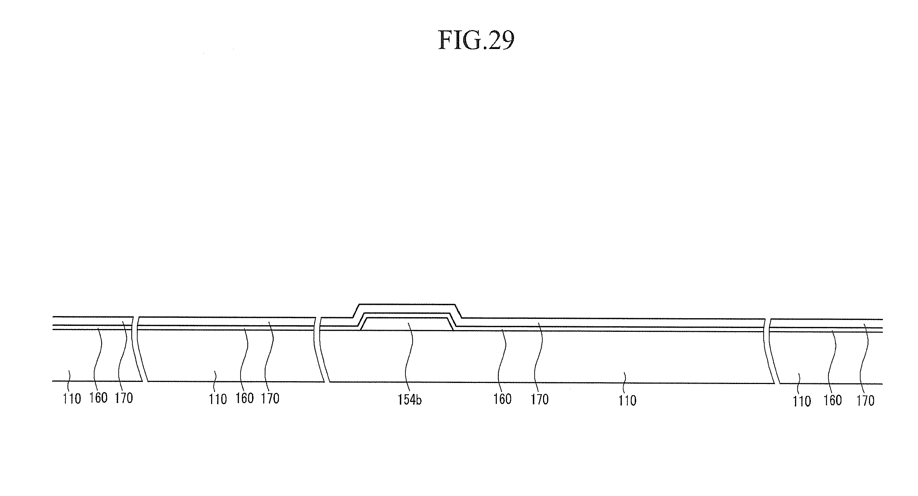

Next, an exemplary manufacturing method of the exemplary OLED shown in FIGs. 27 and 28 will be described with reference to FIGs. 29 to 34 as well as with reference to FIGs. 27 and 28.

FIGs. 29 to 34 are sectional views of the exemplary OLED sequentially showing an exemplary manufacturing method of the exemplary OLED shown in FIGs. 27 and 28.

As shown in FIG. 29, a microcrystalline silicon layer is deposited on an insulating substrate 110 and is photo-etched to form a plurality of driving semiconductor islands 154b.

Alternatively, an a-Si layer may be deposited on the substrate 110, and then crystallized by an SPC process, etc.

Next, an impurity-doped a-Si layer 160 and a metal layer 170 are sequentially deposited on the substrate 110 and the driving semiconductor islands 154b.

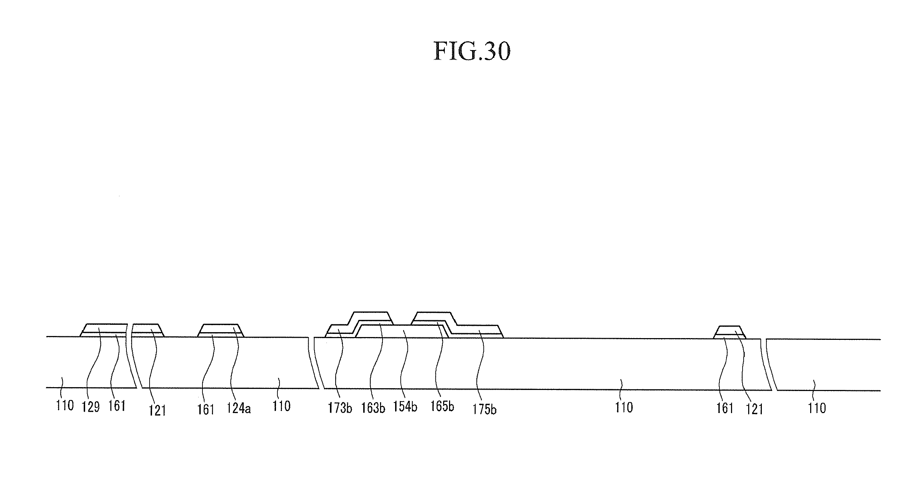

Next, as shown in FIG. 30, the metal layer 170 and the impurity-doped a-Si layer 160 are photo-etched to form a plurality of gate lines 121 including switching control electrodes 124a and end portions 129, a plurality of auxiliary members 161, a plurality of driving voltage lines 172 including driving input electrodes 173b, a plurality of driving output electrodes 175b, and a plurality of pairs of ohmic contact islands 163b and 165b.

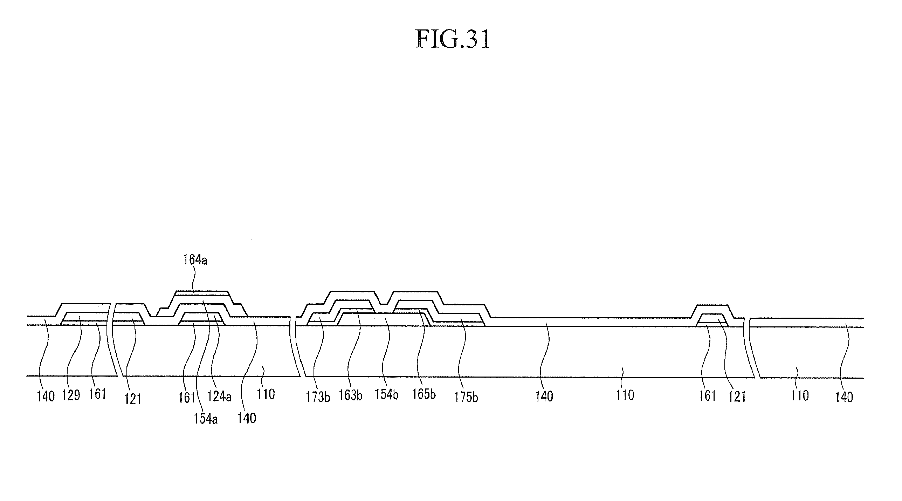

Referring to FIG. 31, a gate insulating layer 140, an intrinsic a-Si layer, and an impurity a-Si layer are sequentially deposited on the substrate 110, the gate lines 121, the driving voltage lines 172, the driving output electrodes 175b, the exposed portions of the substrate 110, and the channel portions of the driving semiconductor islands 154b exposed between the driving output electrodes 175b and the driving input electrodes 173b. Then, photo-etching is performed to form switching semiconductor islands 154a and ohmic contact layers 164a.

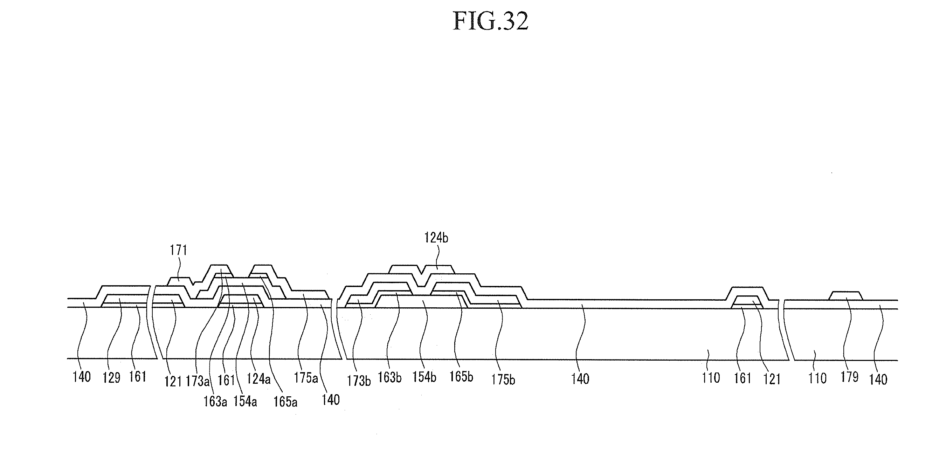

Next, as shown in FIG. 32, a metal layer is deposited on the gate insulating layer 140 and the ohmic contact layers 164a and is photo-etched to form a plurality of data lines 171 including switching input electrodes 173a and end portions 179, a plurality of switching output electrodes 175a, and a plurality of driving control electrodes 124b.

Sequentially, the ohmic contact layers 164a are etched using the data lines 171 having the switching input electrodes 173a and the switching output electrodes 175a as an etch mask to form a plurality of pairs of ohmic contacts 163a and 165a.

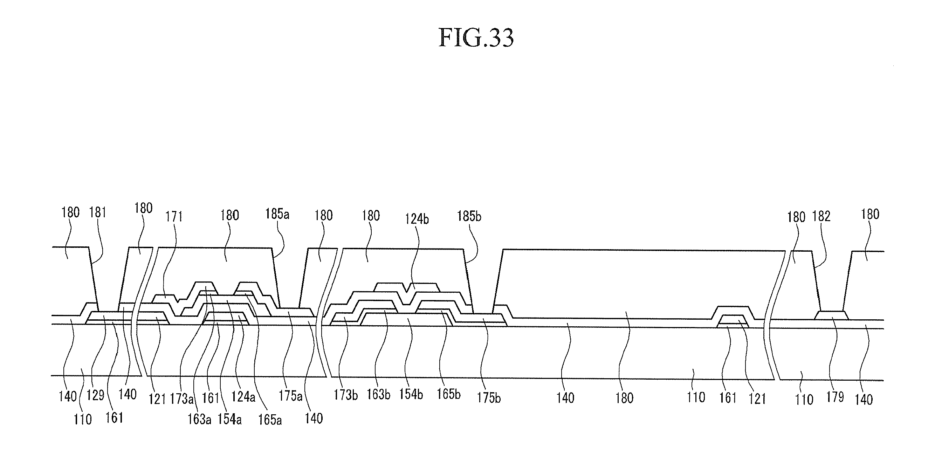

As shown in FIG. 33, a passivation layer 180 is formed on the data lines 171, the switching output electrodes 175a, the driving control electrodes 124b, and the gate insulating layer 140, as well as on channel portions of the switching semiconductor islands 154a exposed between the switching output electrodes 175a and the switching input electrodes 173a. Thereafter, the passivation layer 180 is etched to form a plurality of contact holes 185a, 182, and 184, and the passivation layer 180 and the gate insulating layer 140 are etched to form a plurality of contact holes 181 and 185b.

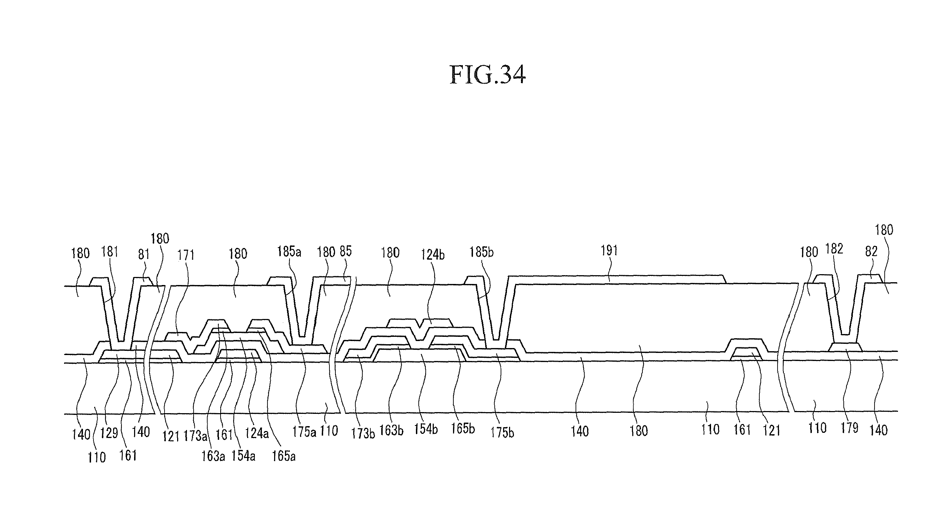

As shown in FIG. 34, ITO is deposited on the passivation layer 180 and is photo-etched to form a plurality of pixel electrodes 191, a plurality of connecting members 85, and a plurality of contact assistants 81 and 82.

Next, with reference to FIGs. 27 and 28, after depositing a photosensitive organic layer on the pixel electrodes 191, the connecting members 85, the contact assistants 81 and 82, and the passivation layer 180, the organic layer is exposed to light and developed to form a partition 361 including a plurality of openings 365. Alternatively, the partition 361 may not be formed on one or both of the contact assistants 81 and 82, or the partition 361 may be removed from one or both of the contact assistants 81 and 82.

Thereafter, a plurality of organic light emitting members 370 of which each includes a hole transport layer (not shown) and an emitting layer (not shown) are formed on the pixel electrodes 191 and confined in the openings 365.

Next, with further reference to FIGs. 27 and 28, a common electrode 270 is formed on the partitions 361 and the organic light emitting members 370.

According to the present invention, the data voltage drop in the switching TFTs is prevented, the reduction of the current amount transmitted to the light emitting devices and the reduction of the lifetime are reduced, and the deterioration of characteristics of the OLED is prevented. Even though the structures of the switching TFTs and the driving TFTs are different, the switching control electrodes, the driving input electrodes, and the driving output electrodes are formed using a mask, and the switching input electrodes, the switching output electrodes and the driving control electrodes are formed using a mask. Thereby, the number of masks used in manufacturing the OLED is reduced.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. An organic light emitting device comprising:
a substrate;
first and second signal lines formed on the substrate;
a switching transistor connected to the first and second signal lines and including a first semiconductor;
a driving transistor connected to the switching transistor and including a second semiconductor;
a first electrode connected to the driving transistor;
a second electrode facing the first electrode; and
a light emitting member formed between the first electrode and the second electrode,
wherein the first semiconductor and the second semiconductor are formed on different layers within the display.

2. The organic light emitting device of claim 1, wherein the first semiconductor has a different crystalline state from a crystalline state of the second semiconductor.

3. The organic light emitting device of claim 2, wherein the first semiconductor comprises an amorphous semiconductor, and the second semiconductor comprises a microcrystalline semiconductor or a polycrystalline semiconductor.

4. The organic light emitting device of claim 3, wherein the switching transistor further comprises:
a first control electrode connected to the first signal line;
a first gate insulating layer formed on the first control electrode;
a first input electrode connected to the second signal line; and
a first output electrode facing the first input electrode and connected to the driving transistor.

5. The organic light emitting device of claim 4, wherein the driving transistor further comprises:
a second control electrode connected to the first output electrode;
a second gate insulating layer formed on the second control electrode;
a second input electrode formed on the second semiconductor, a portion of the second input electrode overlapping the second control electrode and the second semiconductor; and
a second output electrode facing the second input electrode and connected to the first electrode,
wherein the second gate insulating layer is formed under the first control electrode.

6. The organic light emitting device of claim 5, wherein the first control electrode, the second input electrode, and the second output electrode are simultaneously formed using a mask.

7. The organic light emitting device of claim 4, wherein the driving transistor further comprises:
a second input electrode and a second output electrode facing each other on the second semiconductor; and
a second control electrode formed on the second input electrode and the second output electrode to overlap them and the second control electrode connected to the first output electrode.

8. The organic light emitting device of claim 7, wherein the first control electrode, the second input electrode, and the second output electrode are simultaneously formed using a mask.

9. The organic light emitting device of claim 7 or 8, wherein the first input electrode, the first output electrode, and the second control electrode are simultaneously formed using a mask.

10. The organic light emitting display of claim 7, 8 or 9, further comprising ohmic contacts formed on the second input electrode and the second output electrode.

11. The organic light emitting device of claim 7, 8 or 9, further comprising ohmic contacts formed under the second input electrode and the second output electrode.

12. The organic light emitting device of claim 11, wherein the ohmic contacts have a substantially same planar shape as the second input electrode and the second output electrode.

13. The organic light emitting device of claim 11 or 12, further comprising an auxiliary member formed under the first control electrode.

14. The organic light emitting device of claim 13, wherein the ohmic contacts and the auxiliary member comprise at least one of an impurity-doped amorphous silicon semiconductor, an impurity-doped microcrystalline semiconductor, and an impurity-doped crystalline semiconductor.

15. The organic light emitting device of any of claims 7 to 14, wherein the first control electrode is formed under the first semiconductor, and the second control electrode is formed on the second semiconductor.

16. The organic light emitting device of claim 4, wherein the driving transistor further comprises:
a second output electrode connected to the first electrode;
the second input electrode facing the second output electrode; and
a second control electrode formed on the second semiconductor to overlap it and the second control electrode connected to the first output electrode.

17. The organic light emitting device of claim 16, wherein the first control electrode, the second input electrode, and the second output electrode are simultaneously formed using a mask.

18. The organic light emitting device of claim 16 or 17, wherein the first input electrode, the first output electrode, and the second control electrode are simultaneously formed using a mask.

19. The organic light emitting device of claim 16, 17 or 18, wherein the first control electrode is formed under the first semiconductor, and the second control electrode is formed on the second semiconductor.

20. An organic light emitting device comprising:
a substrate;
a first signal line formed on the substrate;
a first control electrode connected to the first signal line;
a second signal line insulated from and intersecting the first signal line;
a first input electrode connected to the second signal line;
a first output electrode facing the first input electrode;
a first semiconductor overlapped by the first input electrode and the first output electrode;
a second control electrode connected to the first output electrode;
a driving voltage line insulated from and intersecting the first signal line or the second signal line;
a second input electrode connected to the driving voltage line;
a second output electrode facing the second input electrode;
a second semiconductor overlapped by the second input electrode and the second output electrode;
a first electrode connected to the second output electrode;
a second electrode facing the first electrode; and
a light emitting member formed between the first electrode and the second electrode,
wherein the first control electrode, the second input electrode, and the second output electrode are formed on a same layer of the device, and
the first input electrode, the first output electrode, and the second control electrode are formed on a same layer of the device.

21. The organic light emitting device of claim 20, wherein the first semiconductor comprises an amorphous semiconductor, and the second semiconductor comprises a microcrystalline semiconductor or a polycrystalline semiconductor.

22. A manufacturing method of an organic light emitting device, the method comprising:
forming a driving control electrode on a substrate;
forming a first gate insulating layer on the driving control electrode;
forming a driving semiconductor on the first gate insulating layer;
depositing and etching a conductive layer on the first gate insulating layer and the driving semiconductor to form a switching control electrode, a driving voltage line having a driving input electrode, and a driving output electrode;
forming a second gate insulating layer on the switching control electrode, the driving voltage line, and the driving output electrode;
forming a switching semiconductor on the second gate insulating layer;
forming a data line having a switching input electrode and a switching output electrode on the second gate insulating layer and the switching semiconductor;
forming a first electrode connected to the driving output electrode;
forming a light emitting member on the first electrode; and
forming a second electrode on the light emitting member.

23. The manufacturing method of claim 22, wherein forming the driving semiconductor comprises depositing a microcrystalline semiconductor.

24. The manufacturing method of claim 22, wherein forming the driving semiconductor comprises forming an amorphous semiconductor, and crystallizing the amorphous semiconductor.

25. The manufacturing method of claim 24, further comprising forming an impurity-doped amorphous semiconductor after forming the amorphous semiconductor of the driving semiconductor, and crystallizing the amorphous semiconductor of the driving semiconductor comprises simultaneously crystallizing the amorphous semiconductor of the driving semiconductor and the impurity-doped amorphous semiconductor.

26. The manufacturing method of claim 24 or 25, wherein crystallizing the amorphous semiconductor of the driving semiconductor and the impurity-doped amorphous semiconductor is performed by a solid phase crystallization process.

27. A manufacturing method of an organic light emitting diode display, the method comprising:
forming a driving semiconductor on a substrate;
depositing and etching a first conductive layer on the substrate and the driving semiconductor to form a switching control electrode, a driving voltage line having a driving input electrode, and a driving output electrode;
forming a gate insulating layer on the switching control electrode, the driving voltage line, and the driving output electrode;
forming a switching semiconductor on the gate insulating layer;
depositing and etching a second conductive layer on the gate insulating layer and the switching semiconductor to form a data line having a switching input electrode, a switching output electrode, and a driving control electrode;
forming a first electrode connected to the driving output electrode;
forming a light emitting member on the first electrode; and
forming a second electrode on the light emitting member.

28. The manufacturing method of claim 27, wherein forming the driving semiconductor comprises:
forming a semiconductor layer on the substrate;
forming an ohmic contact layer on the semiconductor layer; and
etching the semiconductor layer and the ohmic contact layer.

29. The manufacturing method of claim 27, further comprising forming an ohmic contact layer after forming the driving semiconductor, and
etching the ohmic contact layer simultaneously with the first conductive layer.

30. The manufacturing method of claim 27, 28 or 29, wherein forming the driving semiconductor comprises depositing a microcrystalline semiconductor.

31. The manufacturing method of claim 27, 28 or 29, wherein forming the driving semiconductor comprises forming an amorphous semiconductor, and crystallizing the amorphous semiconductor.

32. The manufacturing method of claim 31, further comprising forming an impurity-doped amorphous semiconductor after forming the amorphous semiconductor of the driving semiconductor, and crystallizing the amorphous semiconductor of the driving semiconductor comprises simultaneously crystallizing the amorphous semiconductor of the driving semiconductor and the impurity-doped amorphous semiconductor.

33. The manufacturing method of claim 31, wherein crystallizing the amorphous semiconductor of the driving semiconductor and the impurity-doped amorphous semiconductor is performed by a solid phase crystallization process.

34. A manufacturing method of an organic light emitting device, the method comprising:
depositing and etching a first conductive layer on a substrate to form a switching control electrode, a driving voltage line, and a driving output electrode;
forming a driving semiconductor on the driving voltage line and the driving output electrode;
forming a gate insulating layer on the driving semiconductor and the switching control electrode;
forming a switching semiconductor on the gate insulating layer;
depositing and etching a second conductive layer on the gate insulating layer and the switching semiconductor to form a data line having a switching input electrode, a switching output electrode, and a driving control electrode;
forming a first electrode connected to the driving output electrode;
forming a light emitting member on the first electrode; and
forming a second electrode on the light emitting member.

35. The manufacturing method of claim 34, wherein forming the driving semiconductor comprises depositing a microcrystalline semiconductor.

36. The manufacturing method of claim 34, wherein forming the driving semiconductor comprises forming an amorphous semiconductor, and crystallizing the amorphous semiconductor.

37. The manufacturing method of claim 36, further comprising forming an impurity-doped amorphous semiconductor after forming the amorphous semiconductor of the driving semiconductor, and crystallizing the amorphous semiconductor of the driving semiconductor comprises simultaneously crystallizing the amorphous semiconductor of the driving semiconductor and the impurity-doped amorphous semiconductor.

38. The manufacturing method of claim 36 or 37, wherein crystallizing the amorphous semiconductor of the driving semiconductor and the impurity-doped amorphous semiconductor is performed by a solid phase crystallization process.
